# EUROPEAN PATENT SPECIFICATION

(11) **EP 4 486 092 B1**
(45) Date of publication and mention of the grant of the patent: **19.08.2026**
(21) Application number: 24168995.9
(22) Date of filing: 08.04.2024
(51) Int. Cl.: H10K 59/122, H10K 59/80, H10K 50/844, H10K 50/824

(54) **DISPLAY DEVICE INCLUDING A FLUIDIZED LAYER**
ANZEIGEVORRICHTUNG MIT EINER FLUIDISIERTEN SCHICHT
DISPOSITIF D'AFFICHAGE COMPRENANT UNE COUCHE FLUIDISÉE

(30) Priority: 27.06.2023 KR 20230082298
(43) Date of publication of application: 01.01.2025
(73) Proprietor: Samsung Display Co., Ltd., Yongin-si, Gyeonggi-do 17113 (KR)
(72) Inventor: JEONG, So Yeon, Yongin-si, Gyeonggi-do (KR); LEE, Che Ho, Yongin-si, Gyeonggi-do (KR); JO, Won Je, Yongin-si, Gyeonggi-do (KR); KIM, Jae Hyun, Yongin-si, Gyeonggi-do (KR); CHOI, Young Seo, Yongin-si, Gyeonggi-do (KR)
(74) Representative: Gulde & Partner

(56) References cited:
- EP-A1- 4 326 034
- US-A1- 2023 041 252
- US-B1- 11 527 732

## Description

### TECHNICAL FIELD

The present disclosure relates to a display device and, more specifically, to a display device including a fluidized layer.

### DISCUSSION OF THE RELATED ART

As the information society develops, the demand for display devices for displaying images has increased and diversified. For example, display devices have been applied to various electronic devices such as smartphones, digital cameras, laptop computers, navigation devices, and smart televisions. The display devices may be flat panel display devices such as liquid crystal display (LCD) devices, field emission display devices, or organic light emitting diode (OLED) display devices. Among such flat panel display devices, a light emitting display device may display an image without a backlight unit providing light to a display panel because each of the pixels of the display panel includes light emitting elements that may emit light by themselves.

US 11 527 732 B1 relates to methods of producing organic light-emitting diode (OLED) anode structures resistant to etchants. US 2023/041252 A1 relates to sub-pixel circuits and methods of forming sub-pixel circuits that may be utilized in a display such as an organic light-emitting diode (OLED) display. EP 4 326 034 A1, being an intermediate document according to Article 54(3) EPC, relates to a display apparatus and a method of manufacturing the display apparatus in which each pixel is encapsulated.

### SUMMARY

A display device includes a substrate including an emission area and a non-emission area. A first pixel electrode is disposed on the emission area of the substrate. A pixel defining layer is disposed on the non-emission area of the substrate, overlapping the first pixel electrode, and defining a first opening. A first bank layer is disposed on the pixel defining layer and defines a second opening overlapping the first opening. A second bank layer is disposed on the first bank layer and includes a tip protruding toward the first opening. A first light emitting layer is disposed on the first pixel electrode and is disposed within the first opening. A first common electrode is disposed on the first light emitting layer and is in contact with the first bank layer within the second opening. A first encapsulation layer is disposed on the first common electrode and the second bank layer. The protruding tip of the second bank layer includes a side surface of the second bank layer that protrudes toward the first opening to a greater extent than does a side surface of the first bank layer. The first encapsulation layer includes a first inorganic layer completely covering the first common electrode and the protruding tip of the second bank layer. A first fluidized layer is disposed on the first inorganic layer. The first fluidized layer includes a first portion disposed on the first common electrode and a second portion disposed on the second bank layer. The first portion and the second portion are spaced apart from each other. A fluidized layer is a silicon-based inorganic compound layer configured to planarize a step formed between a lower portion of the tip of the second bank layer and the side surface of the first bank layer.

The first fluidized layer may overlap the protruding tip of the second bank layer.

The first portion may completely cover a portion of the first inorganic layer that overlaps the first opening.

A display device may further include a first electrode pattern surrounding the first opening on the second bank layer and may further include a same material as the first common electrode. The first common electrode and the first electrode pattern may be spaced apart from each other with a space interposed therebetween in portions thereof overlapping the protruding tip of the second bank layer.

The first portion may be disposed in the space between the first common electrode and the first electrode pattern.

The second portion may overlap the first electrode pattern outside of the first opening.

The first inorganic layer and the first fluidized layer may include different materials.

The first fluidized layer may include silicon oxynitride (SiON), silicon nitride (SiN), or silicon oxycarbide (SiOc).

The first encapsulation layer may further include a second inorganic layer completely covering the first fluidized layer and a portion of the first inorganic layer that overlaps the second opening.

The display device may further include an organic encapsulation layer disposed on the first encapsulation layer. One surface of the second inorganic layer may be in contact with the first inorganic layer on the side surface of the second bank layer.

Another surface of the second inorganic layer may be in contact with the organic encapsulation layer on the side surface of the second bank layer.

The first inorganic layer may include a first inclined surface in a portion thereof overlapping the outside of the second opening. The first fluidized layer may include a second inclined surface in a portion thereof overlapping the outside of the second opening, and the second inorganic layer may include a third inclined surface in a portion thereof overlapping an outside of the second opening.

The first inclined surface, the second inclined surface, and the third inclined surface may be aligned with each other, and the first inclined surface, the second inclined surface, and the third inclined surface may be in contact with the organic encapsulation layer.

The first encapsulation layer may further include a second fluidized layer disposed on the second inorganic layer so as to overlap the first opening and a third inorganic layer completely covering the second fluidized layer.

The first encapsulation layer may further include a third fluidized layer disposed on the third inorganic layer so as to overlap the first opening. A fourth inorganic layer may completely cover the third fluidized layer.

A display device, not according to the claimed invention, includes a substrate including an emission area and a non-emission area. A first pixel electrode is disposed on the emission area of the substrate. A pixel defining layer is disposed on the non-emission area of the substrate, overlapping the first pixel electrode, and defining a first opening. A first bank layer is disposed on the pixel defining layer and defines a second opening overlapping the first opening. A second bank layer is disposed on the first bank layer and includes a tip protruding toward the first opening. A first light emitting layer is disposed on the first pixel electrode and is disposed within the first opening. A first common electrode is disposed on the first light emitting layer and is in contact with the first bank layer within the second opening. A first encapsulation layer is disposed on the first common electrode and the second bank layer. The first encapsulating layer includes a first inorganic layer completely covering the first common electrode and the protruding tip of the second bank layer within the second opening, a second inorganic layer disposed on the first inorganic layer, and a first fluidized layer disposed between the first inorganic layer and the second inorganic layer within the first opening. The first inorganic layer and the second inorganic layer are in contact with each other in portions thereof overlapping the outside of the second opening.

The first encapsulation layer may further include a second fluidized layer disposed on the second inorganic layer so as to overlap the first opening and a third inorganic layer completely covering the second fluidized layer.

The first encapsulation layer may further include a third fluidized layer disposed on the third inorganic layer so as to overlap the first opening and a fourth inorganic layer completely covering the third fluidized layer.

A display device includes a substrate including an emission area and a non-emission area. A light emitting element is disposed on the emission area of the substrate. A first bank structure is disposed on the non-emission area of the substrate. A second bank structure is spaced apart from the first bank structure with a separation area interposed therebetween. A first inorganic layer covers the first bank structure and the second bank structure. A first fluidized layer is disposed on the first inorganic layer. A second inorganic layer is disposed on the first fluidized layer. Each of the first bank structure and the second bank structure includes a first surface disposed toward the substrate and a second surface opposite to the first surface. A width of the second surface of the bank structure is greater than the width of the first surface of the bank structure. The first fluidized layer is completely surrounded by the first inorganic layer and a portion of the second inorganic layer that overlaps the separation area between the first bank structure and the second bank structure.

The first fluidized may layer include a first portion disposed in the separation area between the first bank structure and the second bank structure and a second portion disposed on the bank structure. The first portion and the second portion of the first fluidized layer are spaced apart from each other.

### BRIEF DESCRIPTION OF THE DRAWINGS

The above and other aspects and features of the present disclosure will become more apparent by describing in detail embodiments thereof with reference to the attached drawings, in which:
FIG. 1 is a schematic perspective view of an electronic device according to an embodiment of the present disclosure;
FIG. 2 is a perspective view illustrating a display device included in the electronic device according to an embodiment of the present disclosure;
FIG. 3 is a cross-sectional view of the display device of FIG. 2 viewed from a side;
FIG. 4 is a plan view illustrating a display layer of the display device according to an embodiment of the present disclosure;
FIG. 5 is a plan view illustrating an arrangement of emission areas in a first display area of the display device according to an embodiment of the present disclosure;
FIGS. 6 and 7 are cross-sectional views taken along line X1-X1' of FIG. 5;
FIG. 8 is an enlarged cross-sectional view of a first emission area of FIG. 6;
FIG. 9 is an enlarged cross-sectional view of area 'T' of FIG. 8;
FIG. 10 is an enlarged cross-sectional view of area 'P' of FIG. 6;
FIG. 11 is an enlarged cross-sectional view of a first emission area of FIG. 6 according to an embodiment of the present disclosure;
FIG. 12 is an enlarged cross-sectional view of a first emission area of FIG. 6 according to an embodiment of the present disclosure;
FIG. 13 is an enlarged cross-sectional view of a first emission area of FIG. 6 according to an embodiment of the present disclosure, not forming part of the claimed invention;
FIG. 14 is an enlarged cross-sectional view of a first emission area of FIG. 6 according to an embodiment of the present disclosure, not forming part of the claimed invention;
FIG. 15 is an enlarged cross-sectional view of a first emission area of FIG. 6 according to an embodiment of the present disclosure, not forming part of the claimed invention;
FIG. 16 is a cross-sectional view of a first inorganic layer covering a recess part between bank structures according to an embodiment of the present disclosure; and
FIG. 17 is a cross-sectional view of a first inorganic layer covering a recess part between bank structures according to an embodiment of the present disclosure, not forming part of the claimed invention.

### DETAILED DESCRIPTION OF THE EMBODIMENTS

The embodiments of the present invention will now be described more fully hereinafter with reference to the accompanying drawings. This invention may, however, be embodied in different forms and should not necessarily be construed as limited to the embodiments set forth herein. The same reference numbers may indicate the same components throughout the specification and the drawings. In the attached drawings, various thicknesses, lengths, and angles are shown and while the arrangement shown does indeed represent an embodiment of the present invention, it is to be understood that modifications of the various thicknesses, lengths, and angles may be possible within the scope of the present invention and the present invention is not necessarily limited to the particular thicknesses, lengths, and angles shown.

It will also be understood that when a layer is referred to as being "on" another layer or substrate, it can be directly on the other layer or substrate, or intervening layers may also be present. In contrast, when an element is referred to as being "directly on" another element, there are no intervening elements present.

It will be understood that, although the terms "first," "second," "third," or the like may be used herein to describe various elements, these elements should not necessarily be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the scope of the present invention.

Hereinafter, embodiments of the present invention will be described with reference to the accompanying drawings.

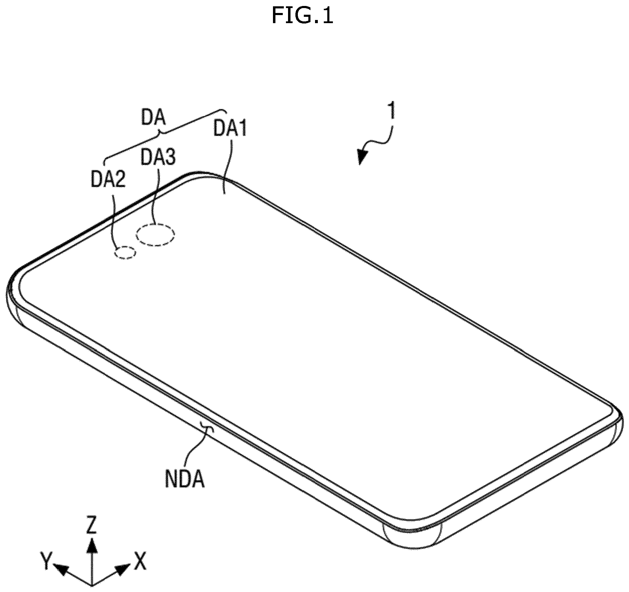

FIG. 1 is a schematic perspective view of an electronic device 1 according to an embodiment of the present disclosure.

Referring to FIG. 1, the electronic device 1 displays a moving image or a still image. The electronic device 1 may refer to all electronic devices that provide display screens. For example, televisions, laptop computers, computer monitors, billboards, the Internet of Things (IoT) devices, mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, and the like, which provide display screens, may be included in the electronic device 1.

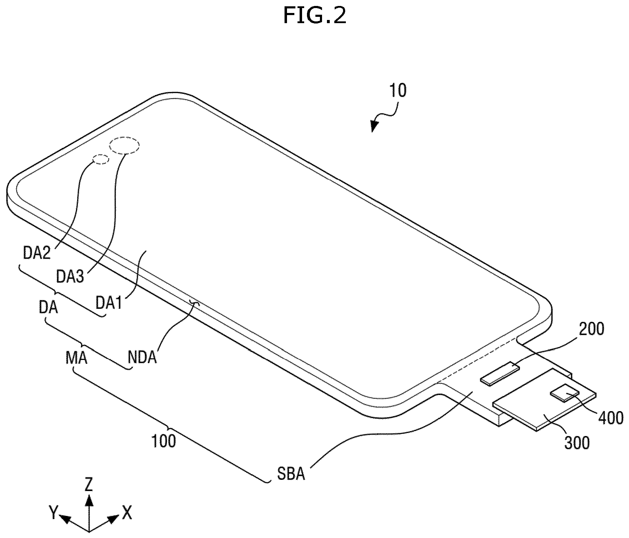

The electronic device 1 may include a display device 10 (see FIG. 2) providing a display screen. Examples of the display device may include an inorganic light emitting diode display device, an organic light emitting display device, a quantum dot light emitting display device, a plasma display device, a field emission display device, and the like. Hereinafter, a case where an organic light emitting diode display device is applied as an example of the display device will be described by way of example, but the present disclosure is not necessarily limited thereto, and other display devices may be utilized.

A shape of the electronic device 1 may be variously modified. For example, the electronic device 1 may have a shape such as a rectangular shape with a width greater than a length, a rectangular shape with a length greater than a width, a square shape, a rectangular shape with rounded corners (vertices), other polygonal shapes, or a circular shape. A shape of a display area DA of the electronic device 1 may also be similar to an overall shape of the electronic device 1. In FIG. 1, the electronic device 1 having a rectangular shape with a greater length in a second direction Y has been illustrated.

The electronic device 1 may include a display area DA and a non-display area NDA. The display area DA is an area in which a screen may be displayed, and the non-display area NDA is an area in which a screen is not displayed. The display area DA may also be referred to as an active area, and the non-display area NDA may also be referred to as a non-active area. The display area DA may occupy substantially the center of the electronic device 1.

The display area DA may include a first display area DA1, a second display area DA2, and a third display area DA3. The second display area DA2 and the third display area DA3 may be areas in which components for adding various functions to the electronic device 1 are disposed, and may correspond to component areas.

FIG. 2 is a perspective view illustrating a display device 10 included in the electronic device 1 according to an embodiment of the present disclosure.

Referring to FIG. 2, the electronic device 1, according to an embodiment of the present disclosure, may include the display device 10. The display device 10 may provide a screen displayed by the electronic device 1. The display device 10 may have a shape similar to that of the electronic device 1, in a plan view. For example, the display device 10 may have a shape similar to a rectangular shape, in a plan view, having shorter sides in a first direction X and longer sides in the second direction Y. A corner where the shorter side in the first direction X and the longer side in the second direction Y meet may be rounded with a particular curvature, but the invention is not necessarily limited thereto, and the corners may also be right-angled. The shape of the display device 10, in a plan view, is not necessarily limited to the rectangular shape, and may be a shape similar to other polygonal shapes, a circular shape, or an elliptical shape.

The display device 10 may include a display panel 100, a display driver 200, a circuit board 300, and a touch driver 400.

The display panel 100 may include a main area MA and a sub-area SBA.

The main area MA may include a display area DA including pixels displaying an image and a non-display area NDA disposed around the display area DA. In addition, the display area DA may include a first display area DA1, a second display area DA2, and a third display area DA3.

The display area DA may emit light from a plurality of emission areas or a plurality of opening areas. For example, the display panel 100 may include pixel circuits including switching elements, a pixel defining film defining the emission areas or the opening areas, and self-light emitting elements. For example, the self-light emitting element may include at least one of an organic light emitting diode (LED) including an organic light emitting layer, a quantum dot LED including a quantum dot light emitting layer, an inorganic LED including an inorganic semiconductor, and a micro LED, but is not necessarily limited thereto.

The non-display area NDA may be an area outside of the display area DA. The non-display area NDA may be defined as an edge area of the main area MA of the display panel 100. The non-display area NDA may include a gate driver supplying gate signals to gate lines, and fan-out lines connecting the display driver 200 and the display area DA to each other.

The sub-area SBA may be an area extending from one side of the main area MA. The sub-area SBA may include a flexible material that may be bent, folded, and rolled to a noticeable degree without cracking or otherwise sustaining damage. For example, when the sub-area SBA is bent, the sub-area SBA may overlap the main area MA in a thickness direction (e.g., third direction Z). The sub-area SBA may include the display driver 200 and pad parts connected to the circuit board 300. In an embodiment of the present disclosure, the sub-area SBA may be omitted, and the display driver 200 and the pad parts may be disposed in the non-display area NDA.

The display driver 200 may output signals and voltages for driving the display panel 100. The display driver 200 may supply data voltages to data lines. The display driver 200 may supply source voltages to power lines and supply gate control signals to the gate driver. The display driver 200 may be formed as an integrated circuit (IC) and mounted on the display panel 100 in a chip on glass (COG) manner, a chip on plastic (COP) manner, or an ultrasonic bonding manner. As an example, the display driver 200 may be disposed in the sub-area SBA, and may overlap the main area MA in the thickness direction by bending of the sub-area SBA. As another example, the display driver 200 may be mounted on the circuit board 300.

The circuit board 300 may be attached onto the pad parts of the display panel 100 using an anisotropic conductive film (ACF). Lead lines of the circuit board 300 may be electrically connected to the pad parts of the display panel 100. The circuit board 300 may be a flexible printed circuit board, a printed circuit board, or a flexible film such as a chip on film.

The touch driver 400 may be mounted on the circuit board 300. The touch driver 400 may be connected to a touch sensing unit of the display panel 100. The touch driver 400 may supply touch driving signals to a plurality of touch electrodes of the touch sensing unit and sense change amounts in capacitance between the plurality of touch electrodes. For example, the touch driving signal may be a pulse signal having a predetermined frequency. The touch driver 400 may decide whether or not an input has occurred and calculate input coordinates, based on the change amounts in capacitance between the plurality of touch electrodes. The touch driver 400 may be formed as an integrated circuit (IC).

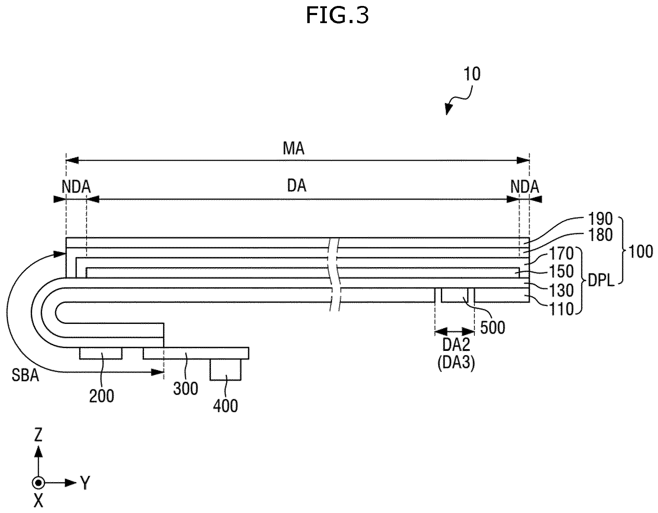

FIG. 3 is a cross-sectional view of the display device 10 of FIG. 2 viewed from a side, wherein the sub-area SBA is bent so to overlap the main area MA in the thickness direction.

Referring to FIG. 3, the display panel 100 may include a display layer DPL, a touch sensing layer 180, and a color filter layer 190. The display layer DPL may include a substrate 110, a thin film transistor layer 130, a light emitting element layer 150, and a thin film encapsulation layer 170.

The substrate 110 may be a base substrate or a base member. The substrate 110 may be a flexible substrate that may be bent, folded, and rolled to a noticeable extent without cracking or otherwise sustaining damage. As an example, the substrate 110 may include a polymer resin such as polyimide (PI), but is not necessarily limited thereto. As another example, the substrate 110 may include a glass material or a metal.

The thin film transistor layer 130 may be disposed on the substrate 110. The thin film transistor layer 130 may include a plurality of thin film transistors constituting pixel circuits of pixels. The thin film transistor layer 130 may further include gate lines, data lines, power lines, gate control lines, fan-out lines connecting the display driver 200 and the data lines to each other, and lead lines connecting the display driver 200 and the pad parts to each other. Each of the thin film transistors may include a semiconductor region, a source electrode, a drain electrode, and a gate electrode. For example, when the gate driver is formed on one side of the non-display area NDA of the display panel 100, the gate driver may include thin film transistors.

The thin film transistor layer 130 may be disposed in the display area DA, the non-display area NDA, and the sub-area SBA. The thin film transistors of each of the pixels, the gate lines, the data lines, and the power lines of the thin film transistor layer 130 may be disposed in the display area DA. The gate control lines and the fan-out lines of the thin film transistor layer 130 may be disposed in the non-display area NDA. The lead lines of the thin film transistor layer 130 may be disposed in the sub-area SBA.

The light emitting element layer 150 may be disposed on the thin film transistor layer 130. The light emitting element layer 150 may include a plurality of light emitting elements each including a first electrode, a second electrode, and a light emitting layer to emit light and a pixel defining film defining the pixels. The plurality of light emitting elements of the light emitting element layer 150 may be disposed in the display area DA.

In an embodiment of the present disclosure, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer 130 and the second electrode receives a cathode voltage, holes and electrons may move to the organic light emitting layer through the hole transporting layer and the electron transporting layer, respectively, and may be combined with each other in the organic light emitting layer to emit light.

**In** an embodiment of the present disclosure, the light emitting element may include a quantum dot light emitting diode including a quantum dot light emitting layer, an inorganic light emitting diode including an inorganic semiconductor, or a micro light emitting diode.

The thin film encapsulation layer 170 may cover an upper surface and side surfaces of the light emitting element layer 150, and may protect the light emitting element layer 150. The thin film encapsulation layer 170 may include at least one inorganic film and at least one organic film for encapsulating the light emitting element layer 150.

The touch sensing layer 180 may be disposed on the thin film encapsulation layer 170. The touch sensing layer 180 may include a plurality of touch electrodes for sensing a user's touch in a capacitance manner and touch lines connecting the plurality of touch electrodes and the touch driver 400 to each other. For example, the touch sensing layer 180 may sense the user's touch in a mutual capacitance manner or a self-capacitance manner.

**In** an embodiment of the present disclosure, the touch sensing layer 180 may be disposed on a separate substrate disposed on the display layer DPL. In this case, the substrate supporting the touch sensing layer 180 may be a base member encapsulating the display layer DPL.

The plurality of touch electrodes of the touch sensing layer 180 may be disposed in a touch sensor area overlapping the display area DA. The touch lines of the touch sensing layer 180 may be disposed in a touch peripheral area overlapping the non-display area NDA.

In some embodiments, the display device 10 may further include an optical device 500. The optical device 500 may be disposed in the second display area DA2 or the third display area DA3. The optical device 500 may emit or receive light of infrared, ultraviolet, and visible light bands. For example, the optical device 500 may be an optical sensor sensing light incident on the display device 10, such as a proximity sensor, an illuminance sensor, and a camera sensor or an image sensor.

The color filter layer 190 may be disposed on the thin film encapsulation layer 170 so as to overlap the emission areas. The color filter layer 190 may include a plurality of color filters respectively corresponding to the plurality of emission areas. Each of the color filters may selectively transmit light of a specific wavelength therethrough and block or absorb light of other wavelengths. The color filter layer 190 may absorb some of light introduced from the outside of the display device 10 to reduce reflected light by external light. Accordingly, the color filter layer 190 may prevent distortion of colors due to external light reflection.

Since the color filter layer 190 is directly disposed on the touch sensing layer 180, the display device 10 might not require a separate substrate for the color filter layer 190. Accordingly, a thickness of the display device 10 may be relatively small.

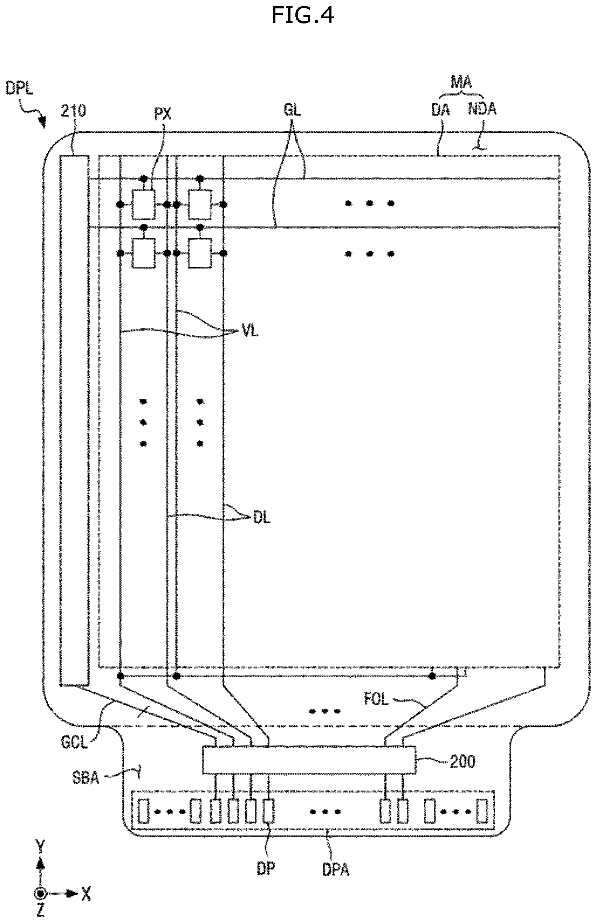

FIG. 4 is a plan view illustrating a display layer DPL of the display device 10 according to an embodiment of the present disclosure.

Referring to FIG. 4, a plurality of pixels PX, a plurality of gate lines GL, a plurality of data lines DL, and a plurality of power lines VL may be disposed in a display area DA of the display layer DPL. Each of the plurality of pixels PX may be defined as a minimum unit emitting light.

The plurality of gate lines GL may supply gate signals received from a gate driver 210 to the plurality of pixels PX. The plurality of gate lines GL may extend in the first direction X, and may be spaced apart from each other in the second direction Y crossing the first direction X.

The plurality of data lines DL may supply data voltages received from the display driver 200 to the plurality of pixels PX. The plurality of data lines DL may extend in the second direction Y, and may be spaced apart from each other in the first direction X.

The plurality of power lines VL may supply a source voltage received from the display driver 200 to the plurality of pixels PX. Here, the source voltage may be a driving voltage, an initialization voltage, a reference voltage, and/or a low potential voltage. The plurality of power lines VL may extend in the second direction Y, and may be spaced apart from each other in the first direction X.

The gate driver 210, fan-out lines FOL, and gate control lines GCL may be disposed in a non-display area NDA of the display layer DPL. The gate driver 210 may generate a plurality of gate signals based on gate control signals, and may sequentially supply the plurality of gate signals to the plurality of gate lines GL according to a set order.

The fan-out lines FOL may extend from the display driver 200 to the display area DA. The fan-out lines FOL may supply the data voltages received from the display driver 200 to the plurality of data lines DL.

The gate control lines GCL may extend from the display driver 200 to the gate driver 210. The gate control lines GCL may supply the gate control signals received from the display driver 200 to the gate driver 210.

The sub-area SBA may include the display driver 200 and a pad area DPA.

The display driver 200 may output signals and voltages for driving the display panel 100 to the fan-out lines FOL. The display driver 200 may supply the data voltages to the data lines DL through the fan-out lines FOL. The data voltages may be supplied to the plurality of pixels PX, and may control luminance of the plurality of pixels PX. The display driver 200 may supply the gate control signals to the gate driver 210 through the gate control lines GCL.

The pad area DPA may be disposed at an edge of the sub-area SBA. The pad area DPA may be electrically connected to the circuit board 300 using a material such as an anisotropic conductive film or self-assembly anisotropic conductive paste (SAP).

The pad area DPA may include a plurality of display pads DP. The plurality of display pads DP may be connected to a graphic system through the circuit board 300. The plurality of display pads DP may be connected to the circuit board 300 to receive digital video data, and may supply the digital video data to the display driver 200.

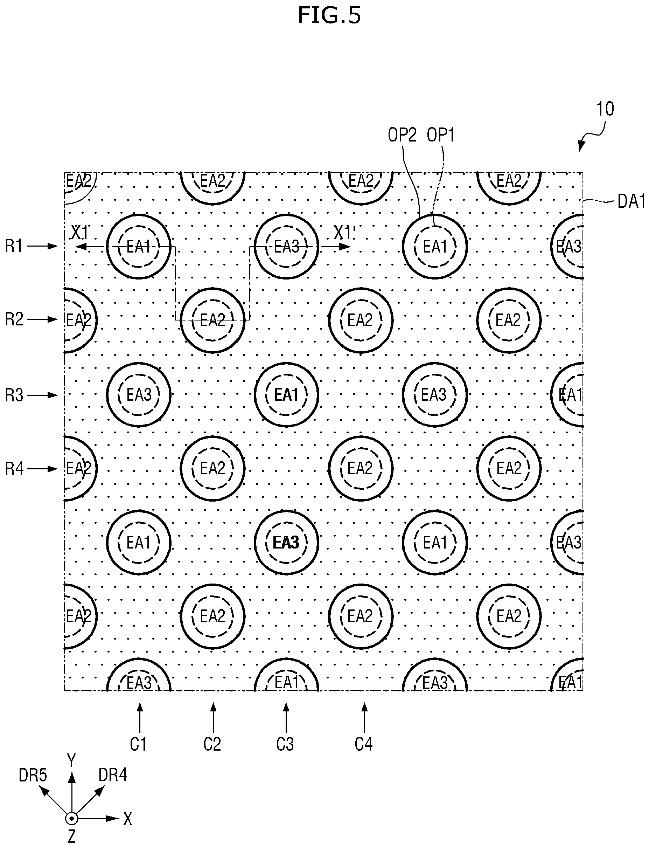

FIG. 5 is a plan view illustrating an arrangement of emission areas EA1, EA2, and EA3 in a first display area DA1 of the display device 10 according to an embodiment of the present disclosure.

Referring to FIG. 5, the display device 10 may include a plurality of emission areas EA1, EA2, and EA3 disposed in the display area DA. The display area illustrated in FIG. 5 is the first display area DA1, and the plurality of emission areas EA1, EA2, and EA3 may be disposed in the first display area DA1. However, the plurality of emission areas EA1, EA2, and EA3 may also be disposed in the second display area DA2 and the third display area DA3 of the display area DA.

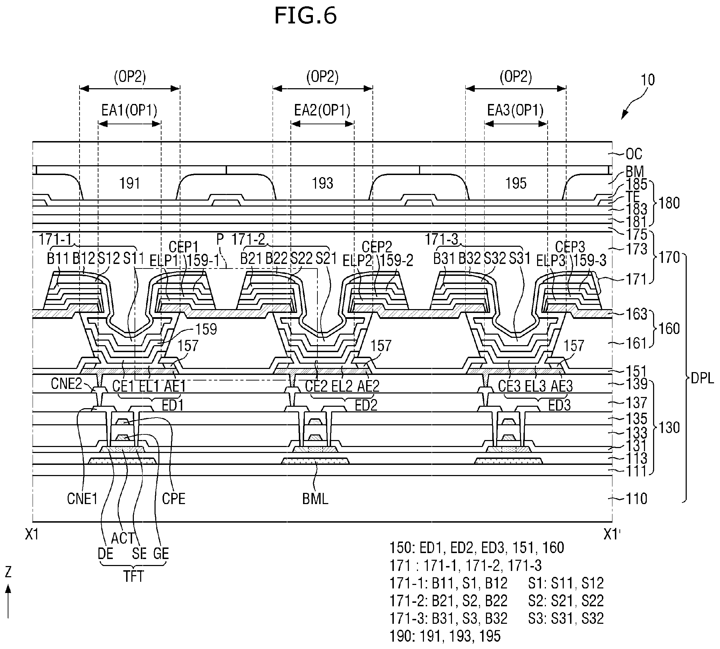

The emission areas EA1, EA2, and EA3 may include first emission areas EA1, second emission areas EA2, and third emission areas EA3 that emit light of different colors. The plurality of emission areas EA1, EA2, and EA3 may emit red, green, or blue light, respectively. Colors of the light emitted from the respective emission areas EA1, EA2, and EA3 may be different from each other depending on types of light emitting elements ED1, ED2, and ED3 (see FIG. 6) disposed at a light emitting element layer 150 to be described later. In an embodiment of the present disclosure, the first emission area EA1 may emit first light, which is the red light, the second emission area EA2 may emit second light, which is the green light, and the third emission area EA3 may emit third light, which is the blue light. However, the present disclosure is not necessarily limited thereto.

The plurality of emission areas EA1, EA2, and EA3 may be disposed in a PENTILE^{™} type, where PENTILE^{™} is a family of subpixel matrix schemes produced by SAMSUNG used in electronic device displays, for example, a diamond PENTILE^{™} type. For example, the first emission areas EA1 and the third emission areas EA3 may be spaced apart from each other in the first direction X, and may be alternately disposed in the first direction X and the second direction Y. In an arrangement of the emission areas EA1, EA2, and EA3, the first emission areas EA1 and the third emission areas EA3 may be alternately disposed in the first direction X in a first row R1 and a third row R3. The first emission areas EA1 and the third emission areas EA3 may be alternately disposed in the second direction Y in a first column C1 and a third column C3.

The second emission areas EA2 may be spaced apart from other adjacent second emission areas EA2 in the first direction X and the second direction Y, and may be spaced apart from adjacent first emission areas EA1 and third emission areas EA3 in a fourth direction DR4 or a fifth direction DR5. A plurality of second emission areas EA2 may be repeatedly disposed along the first direction X and the second direction Y, and the second emission areas EA2 and the first emission areas EA1 or the second emission areas EA2 and the third emission areas EA3 may be alternately disposed along the fourth direction DR4 or the fifth direction DR5. In the arrangement of the emission areas EA1, EA2, and EA3, the second emission areas EA2 may be repeatedly disposed in the first direction X in a second row R2 and a fourth row R4, and the second emission areas EA2 may be repeatedly disposed in the second direction Y in a second column C2 and a fourth column C4.

The plurality of emission areas EA1, EA2, and EA3 may be defined by a plurality of first openings OP1 and second openings OP2 formed by an inorganic pixel defining layer 151 (see FIG. 6) of a light emitting element layer 150 to be described later and a bank structure 160 (see FIG. 6).

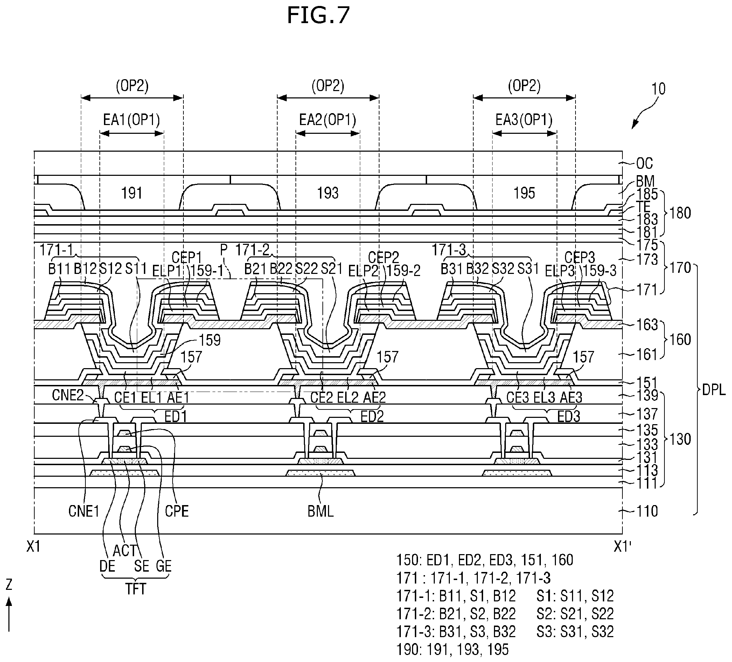

FIGS. 6 and 7 are cross-sectional views of the display device 10 taken along line X1-X1' of FIG. 5.

FIG. 6 is a partial cross-sectional view of the display device 10, and illustrates cross sections of the substrate 110, the thin film transistor layer 130, the light emitting element layer 150, the thin film encapsulation layer 170, the touch sensing layer 180, and the color filter layer 190.

As illustrated in FIG. 6, the display layer DPL may include the substrate 110, the thin film transistor layer 130, the light emitting element layer 150, and the thin film encapsulation layer 170.

The substrate 110 may be substantially the same as the substrate described above with reference to FIG. 3.

The thin film transistor layer 130 may be disposed on the substrate 110. The thin film transistor layer 130 may include a first buffer layer 111, a bottom metal layer BML, a second buffer layer 113, thin film transistors TFT, a gate insulating layer 131, a first interlayer insulating layer 133, capacitor electrodes CPE, a second interlayer insulating layer 135, first connection electrodes CNE1, a first passivation layer 137, second connection electrodes CNE2, and a second passivation layer 139.

The first buffer layer 111 may be disposed on the substrate 110. The first buffer layer 111 may include an inorganic film capable of preventing permeation of air or moisture. For example, the first buffer layer 111 may include a plurality of inorganic films that are alternately stacked.

The bottom metal layer BML may be disposed on the first buffer layer 111. For example, the bottom metal layer BML may be formed as a single layer or multiple layers made of any one of molybdenum (Mo), aluminum (Al), chromium (Cr), gold (Au), titanium (Ti), nickel (Ni), neodymium (Nd), and copper (Cu), or alloys thereof.

The second buffer layer 113 may cover the first buffer layer 111 and the bottom metal layer BML. The second buffer layer 113 may include an inorganic film capable of preventing permeation of air or moisture. For example, the second buffer layer 113 may include a plurality of inorganic films that are alternately stacked.

The thin film transistor TFT may be disposed on the second buffer layer 113, and may constitute a pixel circuit of each of the plurality of pixels. For example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be disposed on the second buffer layer 113. The semiconductor layer ACT may overlap the bottom metal layer BML and the gate electrode GE in the thickness direction, and may be insulated from the gate electrode GE by the gate insulating layer 131. A material of the semiconductor layer ACT in portions of the semiconductor layer ACT may become conductors to form the source electrode SE and the drain electrode DE.

The gate electrode GE may be disposed on the gate insulating layer 131. The gate electrode GE may overlap the semiconductor layer ACT with the gate insulating layer 131 interposed therebetween.

The gate insulating layer 131 may be disposed on the semiconductor layer ACT. For example, the gate insulating layer 131 may cover the semiconductor layer ACT and the second buffer layer 113, and may insulate the semiconductor layer ACT and the gate electrode GE from each other. The gate insulating layer 131 may include contact holes through which the first connection electrodes CNE1 penetrate.

The first interlayer insulating layer 133 may cover the gate electrodes GE and the gate insulating layer 131. The first interlayer insulating layer 133 may include contact holes through which the first connection electrodes CNE1 penetrate. The contact holes of the first interlayer insulating layer 133 may be connected to the contact holes of the gate insulating layer 131 and contact holes of the second interlayer insulating layer 135.

The capacitor electrodes CPE may be disposed on the first interlayer insulating layer 133. The capacitor electrode CPE may overlap the gate electrode GE in the thickness direction. The capacitor electrode CPE and the gate electrode GE may form capacitance (i.e., act as a capacitor).

The second interlayer insulating layer 135 may cover the capacitor electrodes CPE and the first interlayer insulating layer 133. The second interlayer insulating layer 135 may include contact holes through which the first connection electrodes CNE1 penetrate. The contact holes of the second interlayer insulating layer 135 may be connected to the contact holes of the first interlayer insulating layer 133 and the contact holes of the gate insulating layer 131.

The first connection electrodes CNE1 may be disposed on the second interlayer insulating layer 135. The first connection electrode CNE1 may electrically connect the drain electrode DE of the thin film transistor TFT and the second connection electrode CNE2 to each other. The first connection electrode CNE1 may be inserted into the contact holes formed in the second interlayer insulating layer 135, the first interlayer insulating layer 133, and the gate insulating layer 131 to be in contact with the drain electrode DE of the thin film transistor TFT.

The first passivation layer 137 may cover the first connection electrodes CNE1 and the second interlayer insulating layer 135. The first passivation layer 137 may protect the thin film transistors TFT. The first passivation layer 137 may include contact holes through which the second connection electrodes CNE2 penetrate.

The second connection electrodes CNE2 may be disposed on the first passivation layer 137. The second connection electrodes CNE2 may electrically connect the first connection electrodes CNE1 and pixel electrodes AE1, AE2, and AE3 of light emitting elements ED1, ED2, and ED3 to each other. The second connection electrode CNE2 may be inserted into the contact hole formed in the first passivation layer 137 to be in contact with the first connection electrode CNE1.

The second passivation layer 139 may cover the second connection electrodes CNE2 and the first passivation layer 137. The second passivation layer 139 may include contact holes through which the pixel electrodes AE1, AE2, and AE3 of the light emitting elements ED1, ED2, and ED3 penetrate.

The light emitting element layer 150 may be disposed on the thin film transistor layer 130. The light emitting element layer 150 may include the light emitting elements ED1, ED2, and ED3, an inorganic pixel defining film 151, and a plurality of bank structures 160. The light emitting elements ED1, ED2, and ED3 may include the pixel electrodes AE1, AE2, and AE3, light emitting layers EL1, EL2, and EL3, and common electrodes CE1, CE2, and CE3, respectively. The plurality of emission areas EA1, EA2, and EA3 described above may be defined by the first openings OP1 defined by the inorganic pixel defining film 151 of the light emitting element layer 150 and the second openings OP2 defined by the bank structure 160.

The display device 10 may include a plurality of light emitting elements ED1, ED2, and ED3 disposed in different emission areas EA1, EA2, and EA3. The light emitting elements ED1, ED2, and ED3 may include a first light emitting element ED1 disposed in the first emission area EA1, a second light emitting element ED2 disposed in the second emission area EA2, and a third light emitting element ED3 disposed in the third emission area EA3.

The light emitting elements ED1, ED2, and ED3 may include the pixel electrodes AE1, AE2, and AE3, the light emitting layers EL1, EL2, and EL3, and the common electrodes CE1, CE2, and CE3, respectively. The light emitting elements ED1, ED2, and ED3 disposed in the different emission areas EA1, EA2, and EA3 may emit light of different colors depending on materials of the light emitting layers EL1, EL2, and EL3. For example, the first light emitting element ED1 disposed in the first emission area EA1 may emit red light, which is light of a first color, the second light emitting element ED2 disposed in the second emission area EA2 may emit green light, which is light of a second color, and the third light emitting element ED3 disposed in the third emission area EA3 may emit blue light, which is light of a third color. The plurality of emission areas EA1, EA2, and EA3 constituting one pixel may include the light emitting elements ED1, ED2, and ED3 emitting the light of the different colors to express a white gradation.

The pixel electrodes AE1, AE2, and AE3 may be disposed on the second passivation layer 139. The pixel electrodes AE1, AE2, and AE3 may be electrically connected to the drain electrodes DE of the thin film transistors TFT through the first connection electrodes CNE1 and the second connection electrodes CNE2.

The pixel electrodes AE1, AE2, and AE3 may be disposed in the plurality of emission areas EA1, EA2, and EA3, respectively. The pixel electrodes AE1, AE2, and AE3 may include a first pixel electrode AE1 disposed in the first emission area EA1, a second pixel electrode AE2 disposed in the second emission area EA2, and a third pixel electrode AE3 disposed in the third emission area EA3. The first pixel electrode AE1, the second pixel electrode AE2, and the third pixel electrode AE3 may be spaced apart from each other on the second passivation layer 139, respectively. The pixel electrodes AE1, AE2, and AE3 may be disposed in the different emission areas EA1, EA2, and EA3, respectively, to constitute the light emitting elements ED1, ED2, and ED3 emitting the light of the different colors, respectively. In an embodiment of the present disclosure, the pixel electrodes AE1, AE2, and AE3 may have a stacked film structure in which a layer made of a material having a high work function, such indium tin oxide (ITO), indium zinc oxide (IZO), zinc oxide (ZnO), or indium oxide (In₂O₃) and a layer made of a reflective material such as silver (Ag), magnesium (Mg), aluminum (Al), platinum (Pt), lead (Pb), palladium (Pd), gold (Au), nickel (Ni), neodymium (Nd), iridium (Ir), chromium (Cr), lithium (Li), calcium (Ca), or mixtures thereof are stacked. The layer made of the material having the high work function may be disposed at a layer above the layer made of the reflective material to be disposed close to the light emitting layers EL1, EL2, and EL3. As an example, the pixel electrodes AE1, AE2, and AE3 may have a multilayer structure of ITO/Mg, ITO/MgF, ITO/Ag, and ITO/Ag/ITO, but are not necessarily limited thereto.

The display device 10 may include the inorganic pixel defining layer 151 disposed on the second passivation layer 139 and the pixel electrodes AE1, AE2, and AE3. The inorganic pixel defining layer 151 may define the plurality of first openings OP1 forming the emission areas EA1, EA2, and EA3. The inorganic pixel defining layer 151 may be entirely disposed on the second passivation layer 139, but may expose portions of upper surfaces of the pixel electrodes AE1, AE2, and AE3 while partially overlapping the pixel electrodes AE1, AE2, and AE3. For example, the inorganic pixel defining film 151 may expose the pixel electrodes AE1, AE2, and AE3 in portions thereof overlapping the first openings OP1, and the light emitting layers EL1, EL2, and EL3 may be directly disposed on the electrodes AE1, AE2, and AE3, respectively, in the portions of the inorganic pixel defining film 151 overlapping the first openings OP1.

The inorganic pixel defining film 151 may include an inorganic insulating material. As an example, the inorganic pixel defining film 151 may include aluminum oxide, titanium oxide, tantalum oxide, hafnium oxide, zinc oxide, silicon oxide, silicon nitride, and silicon oxynitride.

The bank structure 160 may be disposed on the inorganic pixel defining film 151. The bank structure 160 may define the plurality of second openings OP2 forming the emission areas EA1, EA2, and EA3. The light emitting elements ED1, ED2, and ED3 of the display device 10 may overlap the second openings OP2 of the bank structure 160. The bank structure 160 may include a first bank layer 161 and a second bank layer 163 including different metals and structures. The bank structure 160 will be described in detail later.

The light emitting layers EL1, EL2, and EL3 may be disposed on the pixel electrodes AE1, AE2, and AE3, respectively. The light emitting layers EL1, EL2, and EL3 may be organic light emitting layers made of an organic material, and may be formed on the pixel electrodes AE1, AE2, and AE3, respectively, through a deposition process. When the thin film transistors TFT apply predetermined voltages to the pixel electrodes AE1, AE2, and AE3 of the light emitting elements ED1, ED2, and ED3 and the common electrodes CE1, CE2, and CE3 of the light emitting elements ED1, ED2, and ED3 receives a common voltage or a cathode voltage, holes and electrons may move to the light emitting layers EL1, EL2, and EL3 through hole transporting layers and electron transporting layers, respectively, and may be combined with each other in the light emitting layers EL1, EL2, and EL3 to emit light.

The light emitting layers EL1, EL2, and EL3 may include a first light emitting layer EL1, a second light emitting layer EL2, and a third light emitting layer EL3 disposed in the different emission areas EA1, EA2, and EA3, respectively. The first light emitting layer EL1 may be disposed on the first pixel electrode AE1 in the first emission area EA1, the second light emitting layer EL2 may be disposed on the second pixel electrode AE2 in the second emission area EA2, and the third light emitting layer EL3 may be disposed on the third pixel electrode AE3 in the third emission area EA3. The first to third light emitting layers EL1, EL2, and EL3 may be light emitting layers of the first to third light emitting elements ED1, ED2 and ED3, respectively. The first light emitting layer EL1 may be a light emitting layer emitting the red light, which is the light of the first color, the second light emitting layer EL2 may be a light emitting layer emitting the green light, which is the light of the second color, and the third light emitting layer EL3 may be a light emitting layer emitting the blue light, which is the light of the third color.

In some embodiments, portions of the light emitting layers EL1, EL2, and EL3 may be disposed between the pixel electrodes AE1, AE2, and AE3 and the inorganic pixel defining film 151. For example, the inorganic pixel defining layer 151 may be disposed on the pixel electrodes AE1, AE2, and AE3, but may be spaced apart from the upper surfaces of the pixel electrodes AE1, AE2, and AE3. The deposition process of the light emitting layers EL1, EL2, and EL3 may be performed so that materials of the light emitting layers EL1, EL2, and EL3 are deposited in a direction inclined with respect to an upper surface of the substrate 110 rather than a direction perpendicular to the upper surface of the substrate 110. Accordingly, portions of the light emitting layers EL1, EL2, and EL3 may be disposed between the pixel electrodes AE1, AE2, and AE3 and the inorganic pixel defining film 151. The deposition process of the light emitting layers EL1, EL2, and EL3 will be described in detail later.

In a manufacturing process of the display device 10, a temporary protective layer may be disposed between the inorganic pixel defining layer 151 and the pixel electrodes AE1, AE2, and AE3 and then partially removed. Accordingly, a lower surface of the inorganic pixel defining layer 151 may be spaced apart from the pixel electrodes AE1, AE2, and AE3 in areas in which the temporary protective layer is partially removed. Portions of the temporary protective layer that are not removed may remain as residual patterns 157 in areas between the inorganic pixel defining layer 151 and the pixel electrodes AE1, AE2, and AE3. Accordingly, the areas between the inorganic pixel defining layer 151 and the pixel electrodes AE1, AE2, and AE3 may be filled with the partial residual patterns 157 and the light emitting layers EL1, EL2, and EL3.

The common electrodes CE1, CE2, and CE3 may be disposed on the light emitting layers EL1, EL2, and EL3, respectively. The common electrodes CE1, CE2, and CE3 may include a transparent conductive material to transmit the light generated from the light emitting layers EL1, EL2, and EL3. The common electrodes CE1, CE2, and CE3 may receive a common voltage or a low potential voltage. When the pixel electrodes AE1, AE2, and AE3 receive voltages corresponding to data voltages and the common electrodes CE1, CE2, and CE3 receive the low potential voltage, potential differences are formed between the pixel electrodes AE1, AE2, and AE3 and the common electrodes CE1, CE2, and CE3, such that the light emitting layers EL1, EL2, and EL3 may emit the light. In an embodiment of the present disclosure, the common electrodes CE1, CE2, and CE3 may include a layer made of a material having a small work function, such as Li, Ca, LiF/Ca, LiF/Al, A1, Mg, Ag, Pt, Pd, Ni, Au, Nd, Ir, Cr, BaF, Ba, or compounds or mixtures thereof (e.g., a mixture of Ag and Mg, etc.). The common electrode CE1, CE2, and CE3 may further include a transparent metal oxide layer disposed on the layer made of the material having the small work function.

The common electrodes CE1, CE2, and CE3 may include a first common electrode CE1, a second common electrode CE2, and a third common electrode CE3 disposed in the different emission areas EA1, EA2, and EA3. The first common electrode CE1 may be disposed on the first light emitting layer EL1 in the first emission area EA1, the second common electrode CE2 may be disposed on the second light emitting layer EL2 in the second emission area EA2, and the third common electrode CE3 may be disposed on the third light emitting layer EL3 in the third emission area EA3. The common electrodes CE1, CE2, and CE3 disposed in the different emission areas EA1, EA2, and EA3 are not directly connected to each other, but may be electrically connected to each other through the first bank layer 161 of the bank structure 160.

Capping layers 159 may be disposed on the common electrodes CE1, CE2, and CE3. The capping layers 159 may include an inorganic insulating material and cover the light emitting elements ED1, ED2, and ED3 and patterns disposed on the bank structure 160. The capping layers 159 may prevent damage to the light emitting elements ED1, ED2, and ED3 from external air, and prevent the patterns disposed on the bank structure 160 from being peeled off during the manufacturing process of the display device 10. In an embodiment of the present disclosure, the capping layers 159 may include aluminum oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O).

As illustrated in FIG. 6, the capping layers 159 may partially expose the common electrodes CE1, CE2, and CE3 in portions thereof overlapping the second openings OP2. This may be caused by a step coverage difference in a manufacturing process of forming the capping layers 159 and the common electrodes CE1, CE2, and CE3. However, the present disclosure is not necessarily limited thereto, and as illustrated in FIG. 7, the capping layers 159 may cover the entirety of the common electrodes CE1, CE2, and CE3 in the portions thereof overlapping the second openings OP2.

The thin film encapsulation layer 170 may be disposed on the light emitting elements ED1, ED2, and ED3 and the bank structure 160, and may cover the plurality of light emitting elements ED1, ED2, and ED3 and the bank structure 160. The thin film encapsulation layer 170 may include at least one inorganic film to prevent oxygen or moisture from permeating into the light emitting element layer 150. The thin film encapsulation layer 170 may include at least one organic film to protect the light emitting element layer 150 from foreign substances such as dust.

The thin film encapsulation layer 170 may include a first thin film encapsulation layer 171, a second thin film encapsulation layer 173, and a third thin film encapsulation layer 175 that are sequentially stacked. The first thin film encapsulation layer 171 and the third thin film encapsulation layer 175 may be inorganic encapsulation layers, and the second thin film encapsulation layer 173 disposed between the first thin film encapsulation layer 171 and the third thin film encapsulation layer 175 may be an organic encapsulation layer.

In some embodiments, the first thin film encapsulation layer 171 may have a structure in which barrier layers and fluidized layers are alternately stacked. For example, the first thin film encapsulation layer 171 of the display device 10 may have a structure in which a first inorganic layer B11, a first fluidized layer S1, and a second inorganic layer B12 are sequentially stacked. An uppermost layer disposed at an uppermost portion of the first thin film encapsulation layer 171 may be a barrier layer that prevents moisture permeation.

The first tin film encapsulation layer 171 may include a first encapsulation layer 171-1, a second encapsulation layer 171-2, and a third encapsulation layer 171-3 respectively corresponding to the different emission areas EA1, EA2, and EA3. As an example, the first encapsulation layer 171-1 may overlap the first emission area EA1, the second encapsulation layer 171-2 may overlap the second emission area EA2, and the third encapsulation layer 171-3 may overlap the third emission area EA3. The first to third encapsulation layers 171-1, 171-2, and 171-3 may be regarded as being disposed at the same layer, but may be spaced apart from each other because they are formed in different processes in a manufacturing process. The first to third encapsulation layers 171-1, 171-2, and 171-3 may be directly disposed on the capping layers 159 within the first openings OP1, and may be directly disposed on capping patterns 159-1, 159-2, and 159-3 within the second openings OP2, respectively.

The second thin film encapsulation layer 173 may include a polymer-based material. The polymer-based material may include an acrylic resin, an epoxy-based resin, polyimide, polyethylene, a silicone resin, and the like. For example, the second thin film encapsulation layer 173 may include an acrylic resin such as polymethyl methacrylate or polyacrylic acid. The second thin film encapsulation layer 173 may be formed by curing a monomer or applying a polymer.

The third thin film encapsulation layer 175 may include one or more inorganic insulating materials. The inorganic insulating material may include aluminum oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O).

The touch sensing layer 180 may be disposed on the thin film encapsulation layer 170. The touch sensing layer 180 may include a touch buffer layer 181, a touch insulating layer 183, touch electrodes TE, and a touch protection layer 185.

The touch buffer layer 181 may be disposed on the thin film encapsulation layer 170. The touch buffer layer 181 may have insulating and optical functions. The touch buffer layer 181 may include at least one inorganic film. Optionally, the touch buffer layer 181 may be omitted.

A connection electrode electrically connecting the touch electrodes to each other may be disposed on the touch buffer layer 181.

The connection electrode may be formed as a single layer made of molybdenum (Mo), titanium (Ti), copper (Cu), aluminum (Al), or indium tin oxide (ITO) or be formed as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO.

The touch insulating layer 183 may cover the touch buffer layer 181. The touch insulating layer 183 may have insulating and optical functions. For example, the touch insulating layer 183 may be an inorganic film including at least one of a silicon nitride layer, a silicon oxynitride layer, a silicon oxide layer, a titanium oxide layer, and an aluminum oxide layer.

Some of the touch electrodes TE may be disposed on the touch insulating layer 183. Each of the touch electrodes TE might not overlap the plurality of emission areas EA1, EA2, and EA3. Each of the touch electrodes TE may be formed as a single layer made of molybdenum (Mo), titanium (Ti), copper (Cu), aluminum (Al), or indium tin oxide (ITO) or be formed as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO.

The touch protection layer 185 may cover the touch electrodes TE and the touch insulating layer 183. The touch protection layer 185 may have insulating and optical functions. The touch protection layer 185 may be made of the material exemplified in the touch insulation layer 183.

A light blocking layer BM may be disposed on the touch sensing layer 180. The light blocking layer BM may overlap the inorganic pixel defining layer 151 and the bank structure 160.

The light blocking layer BM may include a light absorbing material. For example, the light blocking layer BM may include an inorganic black pigment or an organic black pigment. The inorganic black pigment may be carbon black, and the organic black pigment may include at least one of lactam black, perylene black, and aniline black, but the present disclosure is not necessarily limited thereto. The light blocking layer BM may prevent color mixing due to permeation of visible light between the plurality of emission areas EA1, EA2, and EA3 to increase a color gamut of the display device 10.

The color filter layer 190 may be disposed on each of the touch protection layer 185 and the light blocking layer BM so as to overlap the emission areas EA1, EA2, and EA3.

The color filter layer 190 may include a first color filter 191, a second color filter 192, and a third color filter 193 respectively corresponding to the different emission areas EA1, EA2, and EA3. A plurality of color filters 191, 193, and 195 may include colorants such as dyes or pigments absorbing light of wavelength bands other than light of a specific wavelength band, and may correspond to the colors of the light emitting from the emission areas EA1, EA2, and EA3. For example, the first color filter 191 may be a red color filter overlapping the first emission area EA1 and transmitting only the first light, which is the red light, therethrough. The second color filter 193 may be a green color filter overlapping the second emission area EA2 and transmitting only the second light, which is the green light, therethrough, and the third color filter 195 may be a blue color filter overlapping the third emission area EA3 and transmitting only the third light, which is the blue light, therethrough.

A structure in which the plurality of color filters 191, 193, and 195 are spaced apart from other adjacent color filters 191, 193, and 195 on the light blocking layer BM has been illustrated in FIG. 6, but the present disclosure is not necessarily limited thereto. For example, the plurality of color filters 191, 193, and 195 may partially overlap other adjacent color filters 191, 193, and 195. Different color filters 191, 193, and 195 may overlap each other on the light blocking layer BM, which is an area that does not overlap the emission areas EA1, EA2, and EA3.

An overcoat layer OC may be disposed on the color filter layer 190 and the light blocking layer BM to planarize upper ends of the plurality of color filters 191, 193, and 195. The overcoat layer OC may be a colorless light transmitting layer that does not have a color of a visible light band. For example, the overcoat layer OC may include a colorless light transmitting organic material such as an acrylic resin.

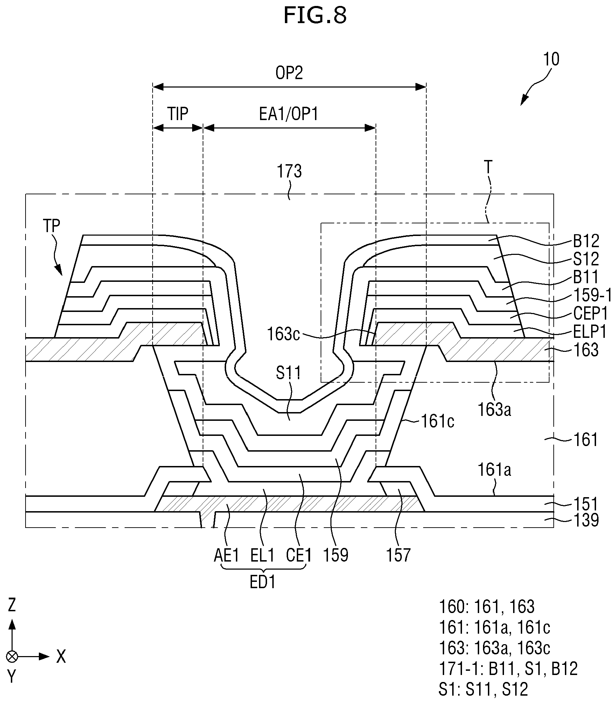

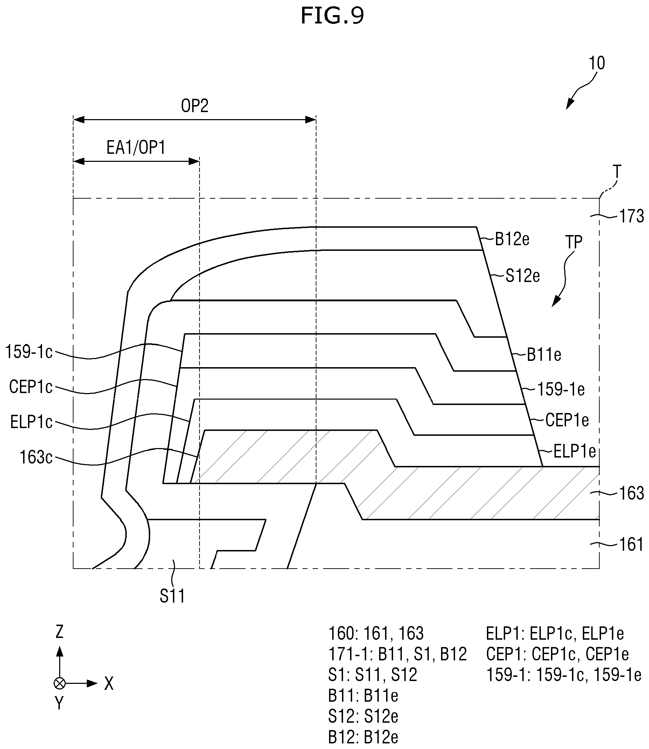

FIG. 8 is an enlarged cross-sectional view of a first emission area EA1 of FIG. 6. FIG. 9 is an enlarged cross-sectional view of area 'T' of FIG. 8.

Referring to FIG. 8, the first bank layer 161 included in the bank structure 160 may be disposed on the inorganic pixel defining layer 151. The first bank layer 161 may include a first surface 161a in contact with the inorganic pixel defining layer 151 and a side surface 161c disposed toward the first opening OP1. The first surface 161a of the first bank layer 161 may be disposed while covering a curvature of the inorganic pixel defining layer 151.

The side surface 161c of the first bank layer 161 may be obliquely inclined between the first direction (e.g., X-axis direction) and the third direction (e.g., Z-axis direction). The bank structure 160 may be formed by deposition and etching processes rather than a mask process, and the first bank layer 161 may be formed by a wet etch process. Accordingly, the side surface 161c of the first bank layer 161 may be depressed in the first direction (e.g., X-axis direction) as compared with the inorganic pixel defining layer 151 to be disposed in a shape of an inclined surface inclined in the first direction (e.g., X-axis direction) based on the third direction (e.g., Z-axis direction).

The first bank layer 161 may include a metal having high electrical conductivity. As an example, the first bank layer 161 may include aluminum (Al) having high electrical conductivity. Accordingly, the first bank layer 161 may be electrically connected to the common electrodes CE1, CE2, and CE3.

The second bank layer 163 may be disposed on the first bank layer 161. The second bank layer 163 may include a material having an etching rate that is lower than that of the first bank layer 161. As an example, the second bank layer 163 may include titanium (Ti).

In some embodiments, the second bank layer 163 may include a first surface 163a facing the first bank layer 161 and a side surface 163c facing the first opening OP1. The second bank layer 163 is formed through a wet etching process like the first bank layer 161, but includes a material relatively stable to the wet etching process as compared with the first bank layer 161, and thus, the side surface 163c of the second bank layer 163 may have a shape in which it protrudes more than the side surface 161c of the first bank layer 161 toward the first opening OP1. For example, the side surface 161c of the first bank layer 161 may have a shape in which it is depressed inward from the side surface 163c of the second bank layer 163. Accordingly, the second bank layer 163 of the bank structure 160 may include a tip TIP protruding toward the first opening OP1, and an undercut may be formed between a lower portion of the tip TIP of the second bank layer 163 and the side surface 161c of the first bank layer 161.

In some embodiments, a material might not be smoothly deposited below the protruding tip TIP of the bank structure 160. Accordingly, materials of the light emitting layers EL1, EL2, and EL3 and the common electrodes CE1, CE2, and CE3 may be designed to be deposited in the direction inclined with respect to the upper surface of the substrate rather than the third direction (e.g., Z-axis direction) perpendicular to the upper surface of the substrate. For example, the deposition process of forming the light emitting layers EL1, EL2, and EL3 may be performed so that the materials of the light emitting layers EL1, EL2, and EL3 are deposited in a direction that is not perpendicular to the upper surfaces of the pixel electrodes AE1, AE2, and AE3, for example, in a direction inclined between the first direction (e.g., X-axis direction) and the third direction (e.g., Z-axis direction). For this reason, the deposition may be performed even in a partial area hidden by the protruding tip TIP of the bank structure 160.

In an embodiment of the present disclosure, when an angle of the deposition process of forming the light emitting layers EL1, EL2, and EL3 is defined as a first angle, the deposition process of forming the light emitting layers EL1, EL2, and EL3 may be performed at an inclined angle of 45° to 50° from the upper surfaces of the pixel electrodes AE1, AE2, and AE3. For example, the first angle may be 40° to 55°. Preferably, the first angle may be 45° to 50°. Accordingly, the light emitting layers EL1, EL2, and EL3 may fill spaces between the pixel electrodes AE1, AE2, and AE3 and the inorganic pixel defining layer 151, and may also be formed on sidewalls of the second openings OP2 in areas hidden by the protruding tips TIP of the bank structure 160.

A deposition process of forming the common electrodes CE1, CE2, and CE3 may also be performed so that the materials of the common electrodes CE1, CE2, and CE3 are deposited in the direction that is not perpendicular to the upper surfaces of the pixel electrodes AE1, AE2, and AE3, for example, in the direction inclined between the first direction (e.g., X-axis direction) and the third direction (e.g., Z-axis direction). In an embodiment of the present disclosure, when an angle of the deposition process of forming the common electrodes CE1, CE2, and CE3 is defined as a second angle, the deposition process of forming the common electrodes CE1, CE2, and CE3 may also be performed at an inclined angle of 40° or less, preferably at an inclined angle of 30° or less from the upper surfaces of the pixel electrodes AE1, AE2, and AE3.

For example, the deposition process of forming the common electrodes CE1, CE2, and CE3 may be performed in an inclined direction closer to a horizontal direction than the deposition process of forming the light emitting layers EL1, EL2, and EL3. Accordingly, the common electrodes CE1, CE2, and CE3 may be in contact with side surfaces of the first bank layer 161 in greater areas than the light emitting layers EL1, EL2, and EL3. Accordingly, the deposition process of forming the common electrodes CE1, CE2, and CE3 may have higher step coverage characteristics than the deposition process of forming the light emitting layers EL1, EL2, and EL3. For example, the common electrodes CE1, CE2, and CE3 may be deposited up to a higher position on the side surfaces 161c of the first bank layer 161 than the light emitting layers EL1, EL2, and EL3.

Referring to FIGS. 6 and 8, the bank structure 160 includes the tips TIP formed in the second bank layer 163, and accordingly, the light emitting layers EL1, EL2, and EL3, the common electrodes CE1, CE2, and CE3, and the capping layers 159 formed by the deposition processes performed over the entire surface of the display area DA may form layers of which materials are disconnected from each other outside of the first openings OP1 of the bank structure 160. Accordingly, patterns including the same materials as the light emitting layers EL1, EL2, and EL3, the common electrodes CE1, CE2, and CE3, and the capping layers 159 may remain on the bank structure 160.

In some embodiments, a plurality of organic patterns ELP1, ELP2, and ELP3, electrode patterns CEP1, CEP2, and CEP3, and capping patterns 159-1, 159-2, and 159-3 may be disposed on the second bank layer 163 of the bank structure 160, and may surround the emission areas EA1, EA2, and EA3 or the first openings OP1. Stacked structures of the plurality of organic patterns ELP1, ELP2, and ELP3, electrode patterns CEP1, CEP2, and CEP3, and capping patterns 159-1, 159-2, and 159-3 disposed around the emission areas EA1, EA2, and EA3 may be partially etched in the manufacturing process of the display device 10, such that pattern shapes may be changed. Accordingly, portions of an upper surface of the second bank layer 163 of the bank structure 160 might not be covered by the plurality of organic patterns ELP1, ELP2, and ELP3, electrode patterns CEP1, CEP2, and CEP3, and capping patterns 159-1, 159-2, and159-3, and trench parts TP may be formed in these portions by the patterns described above.

Each of the plurality of organic patterns ELP1, ELP2, and ELP3 may be disposed on the second bank layer 163 so as to be in partial contact with the second bank 163. The organic patterns ELP1, ELP2, and ELP3 may include the same materials as the light emitting layers EL1, EL2, and EL3 of the light emitting elements ED1, ED2, and ED3, respectively. A first organic pattern ELP1 may include the same material as the first light emitting layer EL1 of the first light emitting element ED1, a second organic pattern ELP2 may include the same material as the second light emitting layer EL2 of the second light emitting element ED2, and a third organic pattern ELP3 may include the same material as the third light emitting layer EL3 of the third light emitting element ED3. Such organic patterns ELP1, ELP2, and ELP3 may be traces formed while deposited materials are disconnected from the light emitting layers EL1, EL2, and EL3 rather than being connected to the light emitting layers EL1, EL2, and EL3 because the bank structure 160 includes the tips TIP. For example, the organic patterns ELP1, ELP2, and ELP3 and the light emitting layers EL1, EL2, and EL3 may be spaced apart from each other by the tips TIP of the bank structure 160.

Referring to FIG. 9, the first organic pattern ELP1 may include a side surface ELP1c of the first organic pattern ELP1 covering the side surface 163c of a portion of the second bank layer 163 that overlaps the second opening OP2. As described above, the deposition process of forming the light emitting layers EL1, EL2, and EL3 may be performed at the inclined angle of 45° to 50° from the upper surfaces of the pixel electrodes AE1, AE2, and AE3, and thus, the first organic pattern ELP1 may be disposed while covering the side surface 163c of the second bank layer 163 in the manufacturing process. In addition, the first organic pattern ELP1 may include an outer surface ELP1e partially etched in the manufacturing process in a portion thereof overlapping the outside of the second opening OP2. The outer surface ELP1e of the first organic pattern ELP1 may form the trench part TP described above, and may be in contact with the second thin film encapsulation layer 173. For convenience of explanation, only the first organic pattern ELP1 has been described, but all of the organic patterns ELP1, ELP2, and ELP3 may have the same structure.

As illustrated in FIG. 6, the plurality of electrode patterns CEP1, CEP2, and CEP3 may be disposed on the plurality of organic patterns ELP1, ELP2, and ELP3, respectively. The electrode patterns CEP1, CEP2, and CEP3 may include a first electrode pattern CEP1, a second electrode pattern CEP2, and a third electrode pattern CEP3 including the same materials as the common electrodes CE1, CE2, and CE3 of the light emitting elements ED1, ED2, and ED3, respectively. For example, the first electrode pattern CEP1, the second electrode pattern CEP2, and the third electrode pattern CEP3 may be directly disposed on the first organic pattern ELP1, the second organic pattern ELP2, and the third organic pattern ELP3, respectively. An arrangement relationship between the electrode patterns CEP1, CEP2, and CEP3 and the organic patterns ELP1, ELP2, and ELP3 may be the same as an arrangement relationship between the light emitting layers EL1, EL2, and EL3 and the common electrodes CE1, CE2, and CE3 of the light emitting elements ED1, ED2, and ED3. Such electrode patterns CEP1, CEP2, and CEP3 may be traces formed while deposited materials are disconnected from the common electrodes CE1, CE2, and CE3 rather than being connected to the common electrodes CE1, CE2, and CE3 because the bank structure 160 includes the tips TIP. In the display device 10, the common electrodes CE1, CE2, and CE3 may be individually formed in different areas even in the deposition process that does not use a mask by the tips TIP of the bank structure 160.

Referring to FIG. 9, the first electrode pattern CEP1 may include a side surface CEP1c of the first electrode pattern CEP1 covering a portion of the side surface ELP1c of the first organic pattern ELP1 that overlaps the second opening OP2. In addition, the first electrode pattern CEP1 may include an outer surface CEPle of the first electrode pattern CEP1 partially etched in the manufacturing process in a portion thereof overlapping the outside of the second opening OP2. The outer surface CEP1e of the first electrode pattern CEP1 may form the trench part TP described above, and may be in contact with the second thin film encapsulation layer 173. For convenience of explanation, only the first electrode pattern CEP1 has been described, but all of the electrode patterns CEP1, CEP2, and CEP3 may have the same structure.

As illustrated in FIG. 6, the capping patterns 159-1, 159-2, and 159-3 may be disposed on the electrode patterns CEP1, CEP2, and CPE3, respectively. The capping patterns 159-1, 159-2, and 159-3 may include the same materials as the capping layers 159 disposed on the common electrodes CE1, CE2, and CE3. The capping patterns 159-1, 159-2, and 159-3 may be directly disposed on the electrode patterns CEP1, CEP2, and CEP3, respectively. An arrangement relationship between the capping patterns 159-1, 159-2, and 159-3 and the electrode patterns CEP1, CEP2, and CEP3 may be the same as an arrangement relationship between the common electrodes CE1, CE2, and CE3 of the light emitting elements ED1, ED2, and ED3 and the capping layers 159. Such capping patterns 159-1, 159-2, and 159-3 may be traces formed while deposited materials are disconnected from the capping layers 159 rather than being connected to the capping layers 159 because the bank structure 160 includes the tips TIP.

Referring to FIG. 9, a first capping pattern 159-1 might not be deposited on the side surface 163c of the second bank layer 163, and may be disposed on the first electrode pattern CEP1. In addition, the first capping pattern 159-1 may include an outer surface 159-1e of the first capping pattern 159-1 partially etched in the manufacturing process in a portion thereof overlapping the outside of the second opening OP2. The outer surface 159-1e of the first capping pattern 159-1 may form the trench part TP, and may be in contact with the second thin film encapsulation layer 173. For convenience of explanation, only the first capping pattern 159-1 has been described, but all of the capping patterns 159-1, 159-2, and 159-3 may have the same structure.

In some embodiments, the first encapsulation layer 171-1 may be disposed while covering the first light emitting element ED1 and a plurality of patterns ELP1, CEP1, and 159-1 disposed on the second bank layer 163. For example, the first encapsulation layer 171-1 may cover the first light emitting element ED1 and the bank structure 160 along an inner sidewall of the second opening OP2, and may be disposed on the bank structure 160 to cover the first organic pattern ELP1, the first electrode pattern CEP1, and the first capping pattern 159-1 disposed around the first opening OP1. However, as illustrated in FIG. 9, the first encapsulation layer 171-1 may be partially etched during the manufacturing process in a portion thereof overlapping the outside of the second opening OP2. Accordingly, the first encapsulation layer 171-1 might not cover the outer surfaces ELP1e, CEP1e, and 159-1e of the plurality of patterns ELP1, CEP1, and 159-1 in the portion thereof overlapping the outside of the second opening OP2.

As illustrated in FIG. 8, the first encapsulation layer 171-1 of the display device 10 may have a structure in which a first inorganic layer B11, a first fluidized layer S1, and a second inorganic layer B12 are stacked. The first inorganic layer B11, the first fluidized layer S1, and the second inorganic layer B12 included in the first encapsulation layer 171-1 may be manufactured in the same process.

In some embodiments, the first inorganic layer B11 may have a function of preventing moisture permeation. The first inorganic layer B11 may be disposed while covering the first light emitting element ED1 and the first capping pattern 159-1 disposed on the bank structure 160. For example, the first inorganic layer B11 may completely cover a portion of the capping layer 159 that overlaps the first opening OP1, and may completely cover a portion of the capping layer 159, the first common electrode CE1, the first bank layer 161, and the second bank layer 163 that overlaps the second opening OP2. In addition, the first inorganic layer B11 may cover an upper portion of the first capping pattern 159-1 outside of the second opening OP2. As an example, the first inorganic layer B11 may include aluminum oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O).

As illustrated in FIG. 9, the first inorganic layer B11 included in the first encapsulation layer 171-1 may be partially etched in the same manufacturing process as the plurality of patterns ELP1, CEP1, and 159-1. Therefore, the first inorganic layer B11 may include a portion of an outer surface B11e of the first inorganic layer B11 that overlaps the outside of the second opening OP2. The outer surface B11e of the first inorganic layer B11 may be aligned with the outer surfaces ELP1e, CEP1e, and 159-1e of the plurality of patterns ELP1, CEP1, and 159-1. Accordingly, the outer surface B11e of the first inorganic layer B11 may form the trench part TP described above, and may be in contact with the second thin film encapsulation layer 173. For convenience of explanation, only the first inorganic layer B11 overlapping the first emission area EA1 has been described, but all of the first inorganic layers B11, B21, and B31 overlapping the respective emission areas EA1, EA2, and EA3 may have the same structure.

The first fluidized layer S1 has characteristics of high mobility. The first fluidized layer S1 planarizes a step of the lower structure. A relatively large physical step is formed between the lower portion of the tip TIP of the second bank layer 163 and the side surface 161c of the first bank layer 161 in the display device 10. In general, when a great step is formed in the display device 10, step coverage characteristics of an inorganic film covering the step may be deteriorated, and accordingly, a crack may be generated in the inorganic film covering the step. The crack generated in the inorganic film as described above may be a permeation path of external oxygen and moisture of the display device 10. However, the first thin film encapsulation layer 171 of the display device 10 includes a material having the characteristics of the high mobility, and accordingly, planarizes a step structure caused in the display device 10. Accordingly, the display device 10 including the first fluidized layer S1 in the first thin film encapsulation layer 171 reduces a defect due to permeation of moisture and oxygen.

The first fluidized layer S1 includes a first portion S11 disposed on the first light emitting element ED1 so as to overlap the first opening OP1 and a second portion S12 disposed on the bank structure 160 outside of the first opening OP1. The first portion S11 of the first fluidized layer S1 and the second portion S12 of the first fluidized layer S1 are spaced apart from each other. The first portion S11 and the second portion S12 of the first fluidized layer S1 may be formed without a separate additional process during the manufacturing process because the first fluidized layer S1 includes mobility or may be formed through a separate additional plasma etching process after the first fluidized layer S1 is formed.

In some embodiments, the first portion S11 of the first fluidized layer S1 may be disposed on the first inorganic layer B11 so as to overlap the second opening OP2. The first portion S11 of the first fluidized layer S1 may planarize a step caused by the first light emitting element ED1, the capping layer 159, and the bank structure 160.

The second portion S12 of the first fluidized layer S1 may be disposed on the first inorganic layer B11 so as to overlap the outside of the second opening OP2. The second portion S12 of the first fluidized layer S1 may be disposed on the second bank layer 163. A thickness of the second portion S12 of the first fluidized layer S1 may decrease in a direction toward the first opening OP1, but is not necessarily limited thereto.

The first fluidized layer S1 includes a silicon-based inorganic compound. As an example, the first fluidized layer S1 may include silicon oxide (SiO₂), silicon nitride (Si₃N₄), and silicon oxynitride (Si₂N₂O).

Referring to FIG. 9, the second portion S12 of the first fluidized layer S1 may include an outer surface S12e of the second part S12 aligned with a portion of the outer surfaces ELP1e, CEP1e, and 159-1e of the plurality of patterns ELP1, CEP1, and 159-1 that overlaps the outside of the second opening OP2. The outer surface S12e of the second portion S12 included in the first fluidized layer S1 may form the trench part TP described above, and may be in contact with the second thin film encapsulation layer 173. For convenience of explanation, only the first fluidized layer S1 overlapping the first emission area EA1 has been described, but all of the first fluidized layers S1, S2, and S3 overlapping the respective emission areas EA1, EA2, and EA3 may have the same structure.

In some embodiments, the second inorganic layer B12 may have characteristics similar to those of the first inorganic layer B11. As an example, the second inorganic layer B12 may have a function of preventing moisture permeation.

In some embodiments, the second inorganic layer B12 may completely cover the first fluidized layer S1 and the first inorganic layer B11 in a portion thereof overlapping the second opening OP2, and may cover an upper surface of the first fluidized layer S1 outside of the second opening OP2. The second inorganic layer B12 may be in contact with the first inorganic layer B11 in a portion which overlaps the second opening OP2 and in which the first fluidized layer S1 is not partially disposed. For example, the first fluidized layer S1 might not be disposed on the side surface 163c of the second bank layer 163. Accordingly, one surface of the second inorganic layer B12 may be in contact with the first inorganic layer B11 on the side surface 163c of the second bank layer 163. For example, another surface of the second inorganic layer B12 may be in contact with the second thin film encapsulation layer 173 on the side surface 163c of the second bank layer 163. For example, the second inorganic layer B12 may be in contact with the first inorganic layer B11 on the side surface ELP1c of the first organic pattern ELP1, the side surface CEP1c of the first electrode pattern CEP1, and the side surface 159-1c of the capping pattern 159-1.

Referring to FIG. 9, the second inorganic layer B12 may include a portion of an outer surface B12e of the second inorganic layer B12 aligned with the outer surfaces ELP1e, CEP1e, and 159-1e of the plurality of patterns ELP1, CEP1, and 159-1 that overlaps the outside of the second opening OP2. The outer surface B12e of the second inorganic layer B12 may form the trench part TP described above. For convenience of explanation, only the second inorganic layer B21 overlapping the first emission area EA1 has been described, but all of the second inorganic layers B12, B22, and B32 overlapping the respective emission areas EA1, EA2, and EA3 may have the same structure.

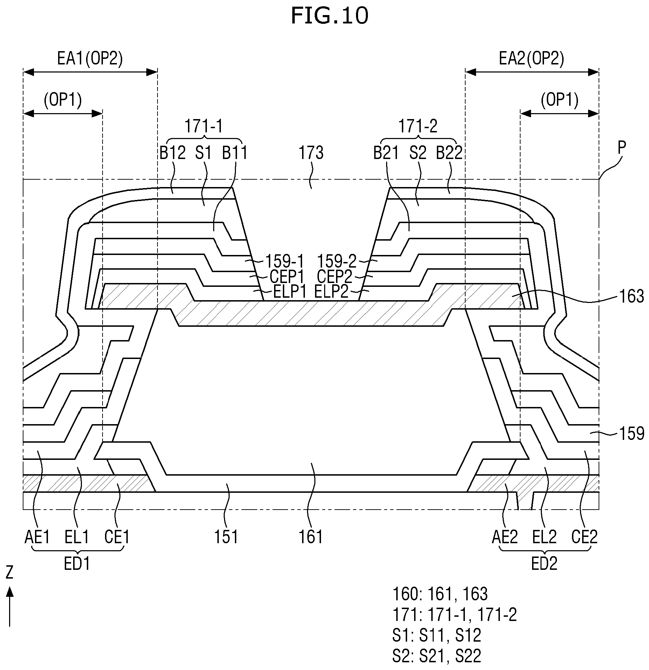

FIG. 10 is an enlarged cross-sectional view of area 'P' of FIG. 6.

As described above, the first to third encapsulation layers 171-1, 171-2, and 171-3 may be regarded as being disposed at the same layer, but may be formed in different processes in the manufacturing process.

Referring to FIGS. 6 and 10, the first encapsulation layer 171-1 may be formed after the first common electrode CE1 is formed, the second encapsulation layer 171-2 may be formed after the second common electrode CE2 is formed, and the third encapsulation layer 171-3 may be formed after the third common electrode CE3 is formed. For example, the first encapsulation layer 171-1 may be formed before the second light emitting element ED2 and the third light emitting element ED3 are formed, and the second encapsulation layer 171-2 may be formed before the third light emitting element ED3 is formed. For example, the first encapsulation layer 171-1 may completely cover the bank structure 160 and the second emission area EA2 and then be partially patterned in the manufacturing process. In addition, the second encapsulation layer 171-2 may completely cover the bank structure 160 and the first emission area EA1 and then be partially patterned, after the first encapsulation layer 171-1 is formed. In addition, the third encapsulation layer 171-3 may completely cover the first emission area EA1, the second emission area EA2, and the bank structure 160 and then be partially patterned, after the second encapsulation layer 171-2 is formed.

Referring to FIG. 10, the first encapsulation layer 171-1 may be partially disposed on the first emission area EA1 and the bank structure 160 around the first emission area EA1. In addition, the second encapsulation layer 171-2 may be partially disposed on the second emission area EA2 and the bank structure 160 around the second emission area EA2. For example, the first encapsulation layer 171-1 and the second encapsulation layer 171-2 may be spaced apart from each other on the second bank layer 163 of the bank structure 160. The second thin film encapsulation layer 173 may be disposed between the first encapsulation layer 171-1 and the second encapsulation layer 171-2 spaced apart from each other. For convenience of explanation, the first encapsulation layer 171-1 and the second encapsulation layer 171-2 have been illustrated and described, but all of the first to third inorganic layers 171-1, 171-2, and 171-3 may have the same structure.

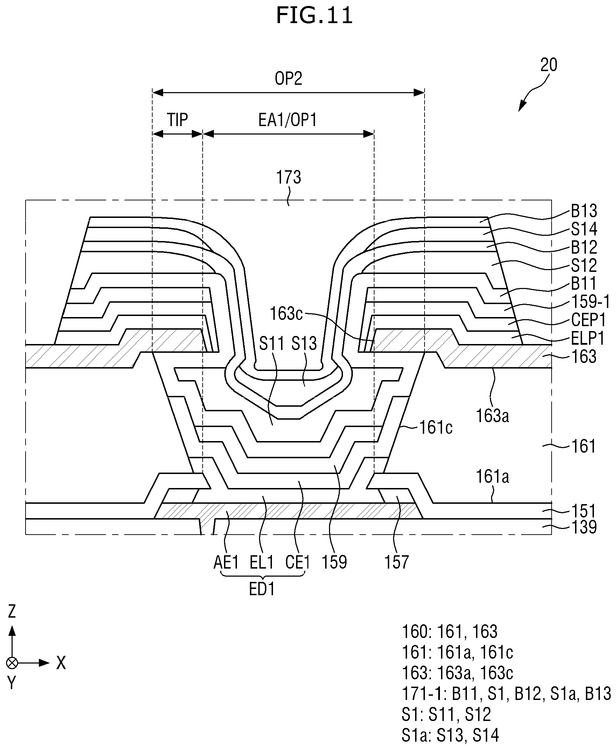

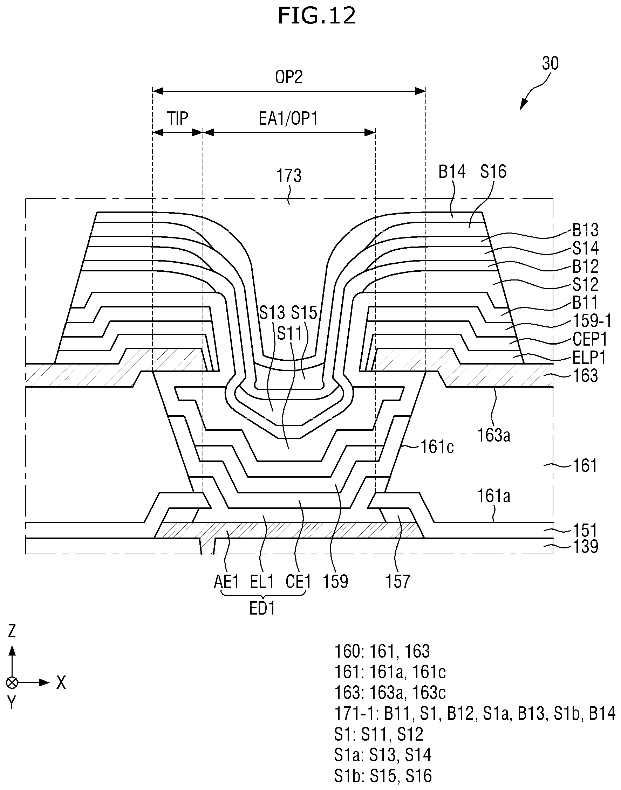

FIGS. 11 and 12 are enlarged cross-sectional views of a first emission area of FIG. 6 according to embodiments of the present disclosure.

Referring to FIG. 11, a display device 20 is different from the display device 10 according to an embodiment of the present disclosure described above in that the first encapsulation layer 171-1 includes a first inorganic layer B11, a first fluidized layer S1, a second inorganic layer B12, a second fluidized layer S1a, and a third inorganic layer B13. The display device 20 may further include the second fluidized layer S1a on the second inorganic layer B12, and may further include the third inorganic layer B13 completely covering the second inorganic layer B12 and the second fluidized layer S1a.

In some embodiments, the second fluidized layer S1a of the display device 20 may have characteristics similar to those of the first fluidized layer S1 of the display device 10. For example, the second fluidized layer S1a may have high mobility and may planarize a step of a lower structure.

The second fluidized layer S1a of the display device 20 may include a first portion S13 disposed on the first light emitting element ED1 so as to overlap the first opening OP1 and a second portion S14 disposed on the second bank layer so as to overlap the second opening OP2. The first portion S13 and the second portion S14 included in the second fluidized layer S1a may be spaced apart from each other.

The third inorganic layer B13 of the display device 20 may have characteristics similar to those of the first inorganic layer B11 and the second inorganic layer B12 of the display device 10. For example, the third inorganic layer B13 may cover a lower structure, and may prevent permeation of oxygen and moisture introduced from the outside of the display device 20. The third inorganic layer B13 of the display device 20 may be an uppermost layer of the first encapsulation layer 171-1. Accordingly, one surface of the third inorganic layer B13 may be in contact with the second fluidized layer S1a and the second inorganic layer B12, and another surface of the third inorganic layer B13 may be in contact with the second thin film encapsulation layer 173. The third inorganic layer B13 may be in contact with the second inorganic layer B12 in a portion where the first portion S13 of the second fluidized bed S1a and the second portion S14 of the second fluidized bed S1a are spaced apart from each other. To the extent that an element is not described in detail with respect to this figure, it may be understood that the element is at least similar to a corresponding element that has been described elsewhere within the present disclosure.

Referring to FIG. 12, a display device 30 is different from the display devices 10 and 20 according to embodiments of the present disclosure described above in that the first encapsulation layer 171-1 includes a first inorganic layer B11, a first fluidized layer S1, a second inorganic layer B12, a second fluidized layer S1a, a third inorganic layer B13, a third fluidized layer S1b, and a fourth inorganic layer B14. The display device 30 may further include the third fluidized layer S1b on the third inorganic layer B13, and may further include the fourth inorganic layer B14 completely covering the third inorganic layer B13 and the third fluidized layer S1b.

In some embodiments of the present disclosure, the third fluidized layer S1b of the display device 30 may have characteristics similar to those of the first fluidized layer S1 and the second fluidized layer S1a of the display device 20, and the fourth inorganic layer B14 of the display device 30 may have characteristics similar to those of the first inorganic layer B11, the second inorganic layer B12, and the third inorganic layer B13 of the display device 20.

The third fluidized layer S1b of the display device 30 may include a first portion S15 disposed on the first light emitting element ED1 so as to overlap the first opening OP1 and a second portion S16 disposed on the second bank layer so as to overlap the second opening OP2. The first portion S15 and the second portion S16 included in the third fluidized layer S1b may be spaced apart from each other.

The fourth inorganic layer B14 of the display device 30 may be in contact with the third inorganic layer B13 in a portion where the first portion S15 of the third fluidized layer S1b and the second portion S16 of the third fluidized layer S1b are spaced apart from each other. The fourth inorganic layer B14 of the display device 30 may be an uppermost layer of the first encapsulation layer 171-1. Accordingly, one surface of the fourth inorganic layer B14 may be in contact with the third fluidized layer S1b and the third inorganic layer B13, and another surface of the fourth inorganic layer B14 may be in contact with the second thin film encapsulation layer 173. Other common descriptions have already been provided, and will thus be omitted.

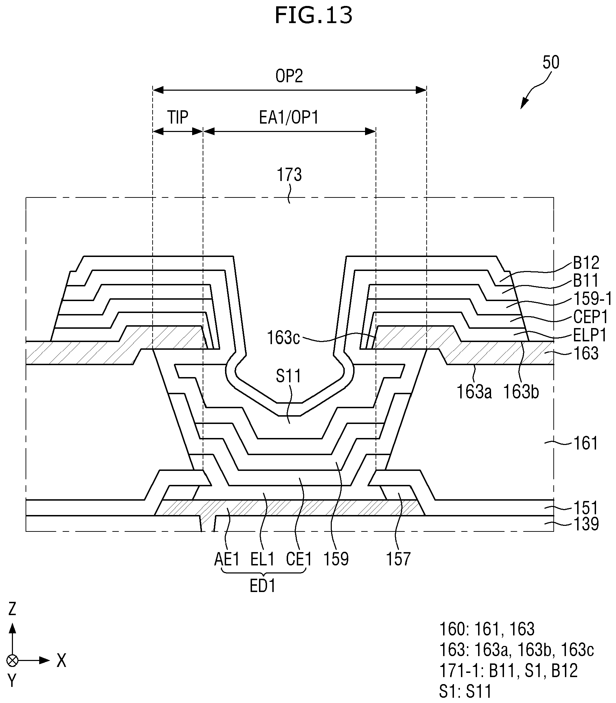

FIGS. 13 to 15 are enlarged cross-sectional views of a first emission area of FIG. 6 according to embodiments of the present disclosure, not forming part of the claimed invention.

Referring to FIG. 13, a display device 50 is different from the display device 10 in that the first fluidized layer S1 of the first encapsulation layer 171-1 includes only the first portion S11. In a process of manufacturing the first fluidized layer S1 of the first encapsulation layer 171-1 in the display device 50, the second portion S12 (see FIG. 8) of the first fluidized layer S1 may be removed through a plasma etching process. A process of etching the second portion S12 of the first fluidized layer S1 may be performed in the same manufacturing process as a process of forming the first fluidized layer S1. Accordingly, the first encapsulation layer 171-1 of the display device 50 may include the first inorganic layer B11, the first portion S11 of the first fluidized layer S1, and the second inorganic layer B12 disposed on the first light emitting element ED1. In addition, the first encapsulation layer 171-1 of the display device 50 may include the first inorganic layer B11 and the second inorganic layer B12 disposed on the second bank layer 163 so as to overlap the second opening OP2. For example, the first fluidized layer S1 is not disposed on the second bank layer 163 of the display device 50, and thus, the first inorganic layer B11 and the second inorganic layer B12 may be in contact with each other on the second bank layer 163.

In the display device 50, the first fluidized layer S1 included in the first encapsulation layer 171-1 includes the first portion S11, and accordingly, a step of the display device 50 may be planarized. In addition, the first fluidized layer S1 is not included on the second bank layer 163 and the first inorganic layer B11 and the second inorganic layer B12 are in contact with each other, and accordingly, a thickness of the display device 50 may be decreased. To the extent that an element is not described in detail with respect to this figure, it may be understood that the element is at least similar to a corresponding element that has been described elsewhere within the present disclosure.

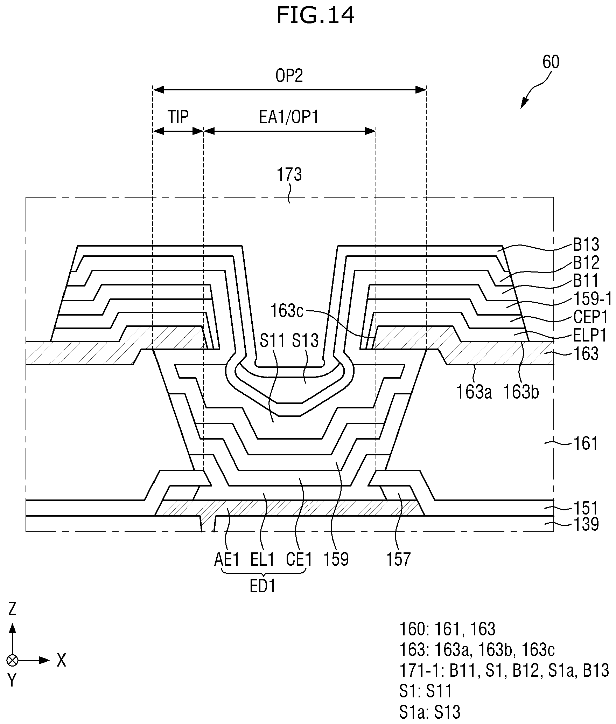

Referring to FIG. 14, a display device 60 is different from the display device 20 in that the first encapsulation layer 171-1 does not include the first fluidized layer S1 and the second fluidized layer S1a on the second bank layer 163. In a manufacturing process of the display device 60, the second portion S12 of the first fluidized layer S1 and the second portion S14 of the second fluidized layer S1a may be removed through a plasma etching process. Accordingly, the first encapsulation layer 171-1 of the display device 60 may decrease a thickness of the display device 60 while planarizing a lower step.

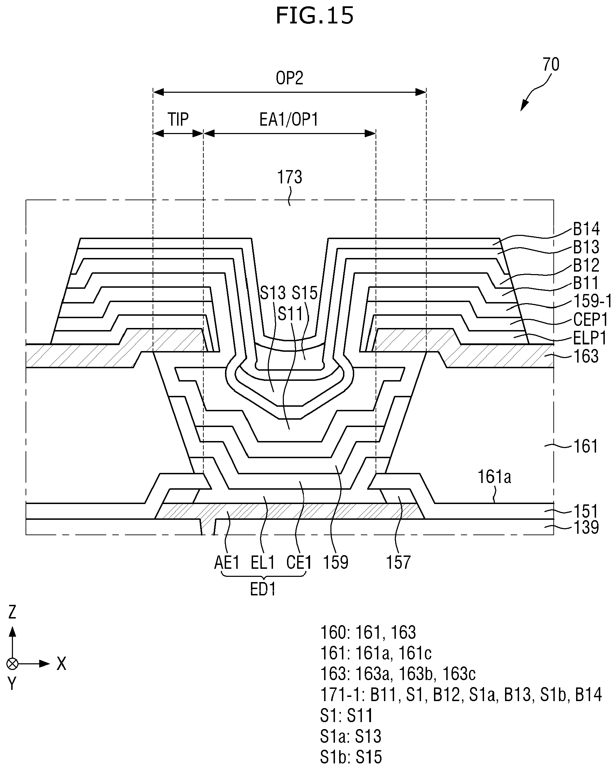

Referring to FIG. 15, a display device 70 is different from the display device 30 in that the first encapsulation layer 171-1 does not include the first fluidized layer S1, the second fluidized layer S1a, and the third fluidized layer S1b on the second bank layer 163. In a manufacturing process of the display device 70, the second portion S12 of the first fluidized layer S1, the second portion S14 of the second fluidized layer S1a, and the second portion S16 of the third fluidized layer S1b may be removed through a plasma etching process. Accordingly, the first encapsulation layer 171-1 of the display device 70 may decrease a thickness of the display device 70 while planarizing a lower step. To the extent that an element is not described in detail with respect to this figure, it may be understood that the element is at least similar to a corresponding element that has been described elsewhere within the present disclosure.

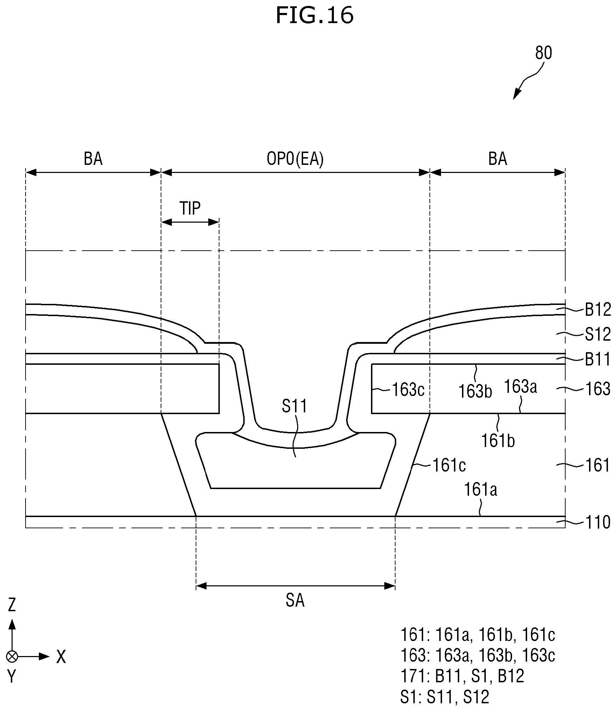

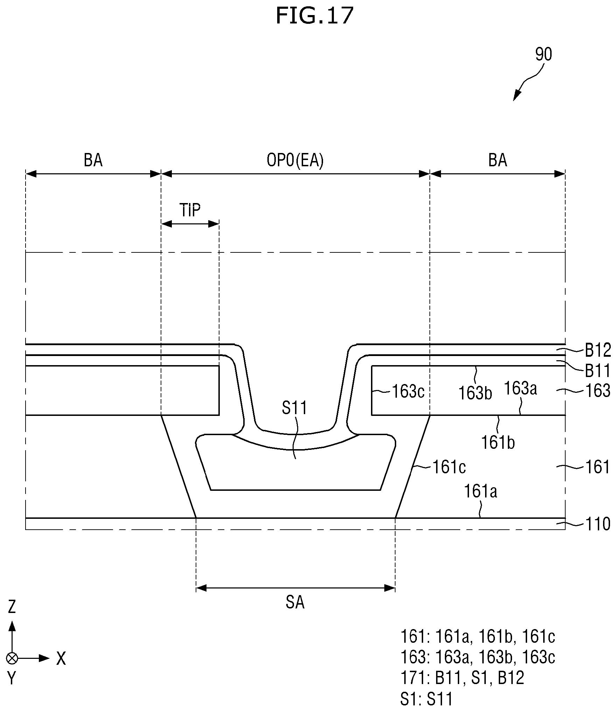

FIGS. 16 and 17 are cross-sectional view of a structure including a recess part between neighboring bank structures according to embodiments of the present disclosure. Fig. 17 is an embodiment not forming part of the claimed invention.

Referring to FIGS. 16 and 17, each of a display device 80 and a display device 90 may include a plurality of bank structures 160 defining an opening OP0.

A substrate 110 of each of the display device 80 and the display device 90 may include an emission area EA and a non-emission area BA.

In some embodiments, the bank structure 160 may be disposed on the non-emission area BA of the substrate 110, and the opening OP0 may be defined by the plurality of bank structures 160 neighboring to each other. Each bank structure 160 may include a first bank layer 161 and a second bank layer 163.

In some embodiments, the first bank layer 161 may include a first surface 161a facing the substrate 110, a second surface 161b opposing the first surface 161a, and a side surface 161c facing the opening OP0. It has been illustrated in FIGS. 16 and 17 that the side surface 161c of the first bank layer 161 is inclined, but the present disclosure is not necessarily limited thereto. For example, the side surface 161c of the first bank layer 161 may be perpendicular to the substrate 110.

The second bank layer 163 may be disposed on the first bank layer 161. The second bank layer 163 may include a first surface 163a facing the first bank layer 161, a second surface 163b opposing the first surface 163a, and a side surface 163c facing the opening OP0.

In some embodiments, a width of the first surface 163a of the second bank layer 163 may be greater than a width of the second surface 161b of the first bank layer 161. In addition, the side surface 163c of the second bank layer 163 may include a tip TIP protruding toward the opening OP0 more than the side surface 161c of the first bank layer 161. Accordingly, an undercut may be formed between the protruding tip TIP of the second bank layer 163 and the side surface 161 c of the first bank layer 161.

In some embodiments, a separation area SA may overlap the opening OP0 between the bank structures 160 spaced apart from each other in the first direction (e.g., X-axis direction). The separation area SA included in each of the display device 80 and the display device 90 may include components constituting a display, such as light emitting elements ED, driving lines, and circuits. Accordingly, the separation area SA of each of the display device 80 and the display device 90 may further include a step due to the components.

A first thin film encapsulation layer 171 may be disposed on the bank structures 160. The first thin film encapsulation layer 171 may completely cover the bank structures 160 that are spaced apart from each other in the first direction (e.g., X-axis direction). For example, the first thin film encapsulation layer 171 may cover inner surfaces of the bank structures 160 in a portion overlapping the opening OPO.

In some embodiments, the first thin film encapsulation layer 171 may have a structure in which an inorganic layer and a fluidized layer are stacked. As an example, the first thin film encapsulation layer 171 of each of the display device 80 and the display device 90 may include a first inorganic layer B11, a first fluidized layer S1, and a second inorganic layer B12.

The first inorganic layer B11 may completely cover the neighboring bank structures 160. For example, the first inorganic layer B11 may extend while covering upper surfaces of the bank structures 160 and the inner surfaces of the bank structures 160 overlapping the opening OP0 without portions partially etched or spaced apart from each other.

The first fluidized layer S1 may be disposed on the first inorganic layer B11.

Referring to FIG. 16, in the display device 80, the first fluidized layer S1 includes a first portion S11 disposed on the substrate 110 so as to overlap the opening OPO and a second portion S12 disposed on the second bank layer 163 so as to overlap the non-emission area BA. The first portion S11 and the second portion S12 of the first fluidized bed S1 are spaced apart from each other.

Referring to FIG. 17, not according to the claimed invention, the display device 90 is different from the display device 80 in that the first fluidized layer S1 includes only the first portion S11 disposed on the substrate 110 so as to overlap the opening OP0. Accordingly, in the display device 90, the first fluidized layer S1 might not be disposed on the second bank layer 163, and the first inorganic layer B11 and the second inorganic layer B12 may be in contact with each other.

Referring to FIGS. 16 and 17, the second inorganic layer B12 may cover the first fluidized layer S1 and the first inorganic layer B11. For example, the second inorganic layer B12 may extend while completely covering the first fluidized layer S1 and the first inorganic layer B11 without portions partially etched or spaced apart from each other. Accordingly, the first fluidized layer S1 of each of the display device 80 and the display device 90 may be completely surrounded by the first inorganic layer B11 and the second inorganic layer B12 in a portion thereof overlapping the separation area SA between the neighboring bank structures 160.

As described above, a relatively large physical step is formed between the lower portion of the tip TIP of the second bank layer 163 and the side surface 161c of the first bank layer 161. In general, in portions in which great steps are formed in the display device 80 and the display device 90, step coverage characteristics of an inorganic film may be deteriorated, and accordingly, a crack may be generated in the inorganic film. The crack generated in the inorganic film as described above may be a permeation path of external oxygen and moisture. Accordingly, the display device 80 and the display device 90 include the first fluidized layer S1 having characteristics of high mobility, and accordingly, steps of the display device 80 and the display device 90 are planarized. For this reason, reliability of the display device 80 and the display device 90 may be increased. To the extent that an element is not described in detail with respect to this figure, it may be understood that the element is at least similar to a corresponding element that has been described elsewhere within the present disclosure.

Embodiments of the present disclosure have been described hereinabove with reference to the accompanying drawings, but it will be understood by one of ordinary skill in the art to which the present disclosure pertains that various modifications and alterations may be made without departing from the scope of the appended claims.

## Claims

1. A display device (10, 20, 30, 50, 60, 70, 80, 90), comprising:
a substrate (110) including an emission area (EA) and a non-emission area (BA);
a first pixel electrode (AE1) disposed on the emission area (EA) of the substrate (110);
a pixel defining layer (151) disposed on the non-emission area (BA) of the substrate (110), partially overlapping the first pixel electrode (AE1), and defining a first opening (OP1);
a first bank layer (161) disposed on the pixel defining layer (151) and defining a second opening (OP2) overlapping the first opening (OP1);
a second bank layer (163) disposed on the first bank layer (161) and including a tip (TIP) protruding toward the first opening (OP1);
a first light emitting layer (EL1) disposed on the first pixel electrode (AE1) and disposed within the first opening (OP1);
a first common electrode (CE1) disposed on the first light emitting layer (EL1) and in contact with the first bank layer (161), within the second opening (OP2); and
a first encapsulation layer (171-1) disposed on the first common electrode (CE1) and the second bank layer (163),
wherein the protruding tip of the second bank layer (163) includes a side surface (163c) of the second bank layer (163) that protrudes toward the first opening (OP1) to a greater extent than does a side surface (161c) of the first bank layer (161),
wherein the first encapsulation layer (171-1) includes a first inorganic layer (B11) completely covering the first common electrode (CE1) and the protruding tip (TIP) of the second bank layer (163), and a first silicon-based inorganic compound layer (S1) configured to planarize a step formed between a lower portion of the tip of the second bank layer and the side surface of the first bank layer and disposed on the first inorganic layer (B11),
wherein the first silicon-based inorganic compound layer (S1) includes a first portion (S11) disposed on the first common electrode (CE1) and a second portion (S12) disposed on the second bank layer (163), and
wherein the first portion (S11) and the second portion (S12) are spaced apart from each other.

2. The display device (10, 20, 30, 50, 60, 70, 80, 90) of claim 1, wherein the first silicon-based inorganic compound layer (S1) overlaps the protruding tip of the second bank layer (163).

3. The display device (10, 20, 30, 50, 60, 70, 80, 90) of claim 1 or 2, wherein the first portion (S11) completely covers a portion of the first inorganic layer (B11) that overlaps the first opening (OP1).

4. The display device (10, 20, 30, 50, 60, 70, 80, 90) of one of the preceding claims, further comprising a first electrode pattern (CEP1) surrounding the first opening (OP1) on the second bank layer (163) and including a same material as the first common electrode (CE1),
wherein the first common electrode (CE1) and the first electrode pattern (CEP1) are spaced apart from each other with a space interposed therebetween in portions thereof overlapping the protruding tip (TIP) of the second bank layer (163).

5. The display device (10, 20, 30, 50, 60, 70, 80, 90) of claim 4, wherein the first portion (S11) is disposed in the space between the first common electrode (CE1) and the first electrode pattern (CEP1).

6. The display device (10, 20, 30, 50, 60, 70, 80, 90) of claim 4 or 5, wherein the second portion (S12) overlaps the first electrode pattern (CEP1) outside of the first opening (OP1).

7. The display device (10, 20, 30, 50, 60, 70, 80, 90) of one of the preceding claims, wherein the first silicon-based inorganic compound layer (S1) includes silicon oxynitride (SiON), silicon nitride (SiN), or silicon oxycarbide (SiOc).

8. The display device (10, 20, 30, 50, 60, 70, 80, 90) of one of the preceding claims, wherein the first encapsulation layer (171-1) further includes a second inorganic layer (B12) completely covering the first silicon-based inorganic compound layer (S1) and a portion of the first inorganic layer (B11) that overlaps the second opening (OP2).

9. The display device (10, 20, 30, 50, 60, 70, 80, 90) of claim 8, further comprising an organic encapsulation layer (173) disposed on the first encapsulation layer (171-1),
wherein one surface of the second inorganic layer (B12) is in contact with the first inorganic layer (B11) on the side surface (163c) of the second bank layer (163).

10. The display device (10, 20, 30, 50, 60, 70, 80, 90) of claim 9, wherein another surface of the second inorganic layer (B12) is in contact with the organic encapsulation layer (173) on the side surface (163c) of the second bank layer (163).

11. The display device (10, 20, 30, 50, 60, 70, 80, 90) of claim 9 or 10, wherein the first inorganic layer (B11) includes a portion (B11e) of a first inclined surface (B11e) that overlaps the outside of the second opening (OP2),
wherein the first silicon-based inorganic compound layer (S1) includes a second inclined surface (S12e) in a portion thereof overlapping the outside of the second opening (OP2), and
wherein the second inorganic layer (B12) includes a third inclined surface (B12e) in a portion thereof overlapping an outside of the second opening (OP2).

12. The display device (10, 20, 30, 50, 60, 70, 80, 90) of claim 11, wherein the first inclined surface (B11e), the second inclined surface (S12e), and the third inclined surface (B12e) are aligned with each other, and
wherein the first inclined surface (B11e), the second inclined surface (S12e), and the third inclined surface (B12e) are in contact with the organic encapsulation layer (173).

13. The display device (10, 20, 30, 50, 60, 70, 80, 90) of claim 8, wherein the first encapsulation layer (171-1) further includes:
a second silicon-based inorganic compound layer (S1a) disposed on the second inorganic layer (B12) so as to overlap the first opening (OP1); and
a third inorganic layer (B13) completely covering the second silicon-based inorganic compound layer (S1a).

14. The display device (10, 20, 30, 50, 60, 70, 80, 90) of claim 13, wherein the first encapsulation layer (171-1) further includes:
a third silicon-based inorganic compound layer (S1b) disposed on the third inorganic layer (B13) so as to overlap the first opening (OP1); and
a fourth inorganic layer (B14) completely covering the third silicon-based inorganic compound layer (S1b).

15. The display device (10, 20, 30, 50, 60, 70, 80, 90) of one of the preceding claims, further comprising:
a first bank structure (160) disposed on the non-emission area of the substrate (110);
a second bank structure (160) spaced apart from the first bank structure (160) with a separation area (SA) interposed therebetween, the first inorganic layer (B11) covering the first bank structure (160) and the second bank structure (160);
a second inorganic layer (B12) disposed on the first silicon-based inorganic compound layer (S1),
wherein each of the first bank structure (160) and the second bank structure (160) includes the first bank layer (161) and the second bank layer (163), wherein a first surface (161a) disposed toward the substrate (110) of the first bank layer (161) is larger than a second surface (161b) of the first bank layer (161) opposite to the first surface (161a),
and
wherein the first silicon-based inorganic compound layer (S1) is completely surrounded by the first inorganic layer (B11) and the second inorganic layer (B12) in a portion thereof overlapping the separation area (SA) between the first bank structure (160) and the second bank structure (160).

## Patentansprüche

1. Anzeigevorrichtung (10, 20, 30, 50, 60, 70, 80, 90), umfassend:
ein Substrat (110) mit einem Emissionsbereich (EA) und einem Nicht-Emissionsbereich (BA);
eine erste Pixelelektrode (AE1), die auf dem Emissionsbereich (EA) des Substrats (110) angeordnet ist;
eine Pixeldefinitionsschicht (151), die auf dem Nicht-Emissionsbereich (BA) des Substrats (110) angeordnet ist, die erste Pixelelektrode (AE1) teilweise überlappt und eine erste Öffnung (OP1) definiert;
eine erste Bankschicht (161), die auf der Pixeldefinitionsschicht (151) angeordnet ist und eine zweite Öffnung (OP2) definiert, die die erste Öffnung (OP1) überlappt;
eine zweite Bankschicht (163), die auf der ersten Bankschicht (161) angeordnet ist und eine in Richtung der ersten Öffnung (OP1) vorstehende Spitze (TIP) umfasst;
eine erste lichtemittierende Schicht (EL1), die sich auf der ersten Pixelelektrode (AE1) befindet und innerhalb der ersten Öffnung (OP1) angeordnet ist;
eine erste gemeinsame Elektrode (CE1), die auf der ersten lichtemittierenden Schicht (EL1) angeordnet ist und innerhalb der zweiten Öffnung (OP2) mit der ersten Bankschicht (161) in Kontakt steht; und
eine erste Verkapselungsschicht (171-1), die auf der ersten gemeinsamen Elektrode (CE1) und der zweiten Bankschicht (163) angeordnet ist,
wobei die vorstehende Spitze der zweiten Bankschicht (163) eine Seitenfläche (163c) der zweiten Bankschicht (163) umfasst, die stärker in Richtung der ersten Öffnung (OP1) vorsteht als eine Seitenfläche (161c) der ersten Bankschicht (161),
wobei die erste Verkapselungsschicht (171-1) eine erste anorganische Schicht (B11), die die erste gemeinsame Elektrode (CE1) und die vorstehende Spitze (TIP) der zweiten Bankschicht (163) vollständig bedeckt, und eine erste anorganische Verbindungsschicht auf Siliziumbasis (S1) umfasst, die dazu konfiguriert ist, eine zwischen einem unteren Abschnitt der Spitze der zweiten Bankschicht und der Seitenfläche der ersten Bankschicht ausgebildete Stufe zu planarisieren, und die auf der ersten anorganischen Schicht (B11) angeordnet ist,
wobei die erste anorganische Verbindungsschicht auf Siliziumbasis (S1) einen ersten Abschnitt (S11), der auf der ersten gemeinsamen Elektrode (CE1) angeordnet ist, und einen zweiten Abschnitt (S12) umfasst, der auf der zweiten Bankschicht (163) angeordnet ist, und
wobei der erste Abschnitt (S11) und der zweite Abschnitt (S12) voneinander beabstandet sind.

2. Anzeigevorrichtung (10, 20, 30, 50, 60, 70, 80, 90) nach Anspruch 1, wobei die erste anorganische Verbindungsschicht auf Siliziumbasis (S1) die vorstehende Spitze der zweiten Bankschicht (163) überlappt.

3. Anzeigevorrichtung (10, 20, 30, 50, 60, 70, 80, 90) nach Anspruch 1 oder 2, wobei der erste Abschnitt (S11) einen Abschnitt der ersten anorganischen Schicht (B11), der die erste Öffnung (OP1) überlappt, vollständig bedeckt.

4. Anzeigevorrichtung (10, 20, 30, 50, 60, 70, 80, 90) nach einem der vorstehenden Ansprüche, umfassend ferner ein erstes Elektrodenmuster (CEP1), das die erste Öffnung (OP1) auf der zweiten Bankschicht (163) umgibt und ein gleiches Material wie die erste gemeinsame Elektrode (CE1) enthält,
wobei die erste gemeinsame Elektrode (CE1) und das erste Elektrodenmuster (CEP1) in Abschnitten davon, die die vorstehende Spitze (TIP) der zweiten Bankschicht (163) überlappen, durch einen dazwischenliegenden Raum voneinander beabstandet sind.

5. Anzeigevorrichtung (10, 20, 30, 50, 60, 70, 80, 90) nach Anspruch 4, wobei der erste Abschnitt (S11) in dem Raum zwischen der ersten gemeinsamen Elektrode (CE1) und dem ersten Elektrodenmuster (CEP1) angeordnet ist.

6. Anzeigevorrichtung (10, 20, 30, 50, 60, 70, 80, 90) nach Anspruch 4 oder 5, wobei der zweite Abschnitt (S12) das erste Elektrodenmuster (CEP1) außerhalb der ersten Öffnung (OP1) überlappt.

7. Anzeigevorrichtung (10, 20, 30, 50, 60, 70, 80, 90) nach einem der vorstehenden Ansprüche, wobei die erste anorganische Verbindungsschicht auf Siliziumbasis (S1) Siliziumoxynitrid (SiON), Siliziumnitrid (SiN) oder Siliziumoxycarbid (SiOc) enthält.

8. Anzeigevorrichtung (10, 20, 30, 50, 60, 70, 80, 90) nach einem der vorstehenden Ansprüche, wobei die erste Verkapselungsschicht (171-1) ferner eine zweite anorganische Schicht (B12), die die erste anorganische Verbindungschicht auf Siliziumbasis (S1) vollständig bedeckt, und einen Abschnitt der ersten anorganischen Schicht (B11) umfasst, der die zweite Öffnung (OP2) überlappt.

9. Anzeigevorrichtung (10, 20, 30, 50, 60, 70, 80, 90) nach Anspruch 8, umfassend ferner eine organische Verkapselungsschicht (173), die auf der ersten Verkapselungsschicht (171-1) angeordnet ist,
wobei eine Oberfläche der zweiten anorganischen Schicht (B12) mit der ersten anorganischen Schicht (B11) auf der Seitenfläche (163c) der zweiten Bankschicht (163) in Kontakt steht.

10. Anzeigevorrichtung (10, 20, 30, 50, 60, 70, 80, 90) nach Anspruch 9, wobei eine weitere Oberfläche der zweiten anorganischen Schicht (B12) mit der organischen Verkapselungsschicht (173) auf der Seitenfläche (163c) der zweiten Bankschicht (163) in Kontakt steht.

11. Anzeigevorrichtung (10, 20, 30, 50, 60, 70, 80, 90) nach Anspruch 9 oder 10, wobei die erste anorganische Schicht (B11) einen Abschnitt (B11e) einer ersten geneigten Oberfläche (B11e) umfasst, der die Außenseite der zweiten Öffnung (OP2) überlappt,
wobei die erste anorganische Verbindungsschicht auf Siliziumbasis (S1) in einem Abschnitt davon, der die Außenseite der zweiten Öffnung (OP2) überlappt, eine zweite geneigte Oberfläche (S12e) umfasst, und
wobei die zweite anorganische Schicht (B12) in einem Abschnitt davon, der die Außenseite der zweiten Öffnung (OP2) überlappt, eine dritte geneigte Oberfläche (B12e) umfasst.

12. Anzeigevorrichtung (10, 20, 30, 50, 60, 70, 80, 90) nach Anspruch 11, wobei die erste geneigte Oberfläche (B11e), die zweite geneigte Oberfläche (S12e) und die dritte geneigte Oberfläche (B12e) miteinander ausgerichtet sind, und
wobei die erste geneigte Oberfläche (B11e), die zweite geneigte Oberfläche (S12e) und die dritte geneigte Oberfläche (B12e) mit der organischen Verkapselungsschicht (173) in Kontakt stehen.

13. Anzeigevorrichtung (10, 20, 30, 50, 60, 70, 80, 90) nach Anspruch 8, wobei die erste Verkapselungsschicht (171-1) ferner Folgendes umfasst:
eine zweite anorganische Verbindungsschicht auf Siliziumbasis (S1a), die auf der zweiten anorganischen Schicht (B12) so angeordnet ist, dass sie die erste Öffnung (OP1) überlappt; und
eine dritte anorganische Schicht (B13), die die zweite anorganische Verbindungsschicht auf Siliziumbasis (S1a) vollständig bedeckt.

14. Anzeigevorrichtung (10, 20, 30, 50, 60, 70, 80, 90) nach Anspruch 13, wobei die erste Verkapselungsschicht (171-1) ferner Folgendes umfasst:
eine dritte anorganische Verbindungsschicht auf Siliziumbasis (S1b), die auf der dritten anorganischen Schicht (B13) so angeordnet ist, dass sie die erste Öffnung (OP1) überlappt; und
eine vierte anorganische Schicht (B14), die die dritte anorganische Verbindungsschicht auf Siliziumbasis (S1b) vollständig bedeckt.

15. Anzeigevorrichtung (10, 20, 30, 50, 60, 70, 80, 90) nach einem der vorstehenden Ansprüche, umfassend ferner:
eine erste Bankstruktur (160), die auf dem Nicht-Emissionsbereich des Substrats (110) angeordnet ist;
eine zweite Bankstruktur (160), die von der ersten Bankstruktur (160) mit einem dazwischen angeordneten Trennbereich (SA) beabstandet ist, wobei die erste anorganische Schicht (B11) die erste Bankstruktur (160) und die zweite Bankstruktur (160) bedeckt;
eine zweite anorganische Schicht (B12), die auf der ersten anorganischen Verbindungsschicht auf Siliziumbasis (S1) angeordnet ist,
wobei jede von der ersten Bankstruktur (160) und der zweiten Bankstruktur (160) die erste Bankschicht (161) und die zweite Bankschicht (163) umfassen, wobei eine dem Substrat (110) zugewandte erste Oberfläche (161a) der ersten Bankschicht (161) größer ist als eine der ersten Oberfläche (161a) gegenüberliegende zweite Oberfläche (161b) der ersten Bankschicht (161),
und
wobei die erste anorganische Verbindungsschicht auf Siliziumbasis (S1) in einem Abschnitt davon, der den Trennbereich (SA) zwischen der ersten Bankstruktur (160) und der zweiten Bankstruktur (160) überlappt, vollständig von der ersten anorganischen Schicht (B11) und der zweiten anorganischen Schicht (B12) umgeben ist.

## Revendications

1. Dispositif d'affichage (10, 20, 30, 50, 60, 70, 80, 90), comportant:
un substrat (110) incluant une zone d'émission (EA) et une zone de non-émission (BA);
une première électrode de pixel (AE1) disposée sur la zone d'émission (EA) du substrat (110);
une couche de définition de pixel (151) disposée sur la zone de non-émission (BA) du substrat (110), chevauchant partiellement la première électrode de pixel (AE1), et définissant une première ouverture (OP1);
une première couche de bord (161) disposée sur la couche de définition de pixel (151) et définissant une deuxième ouverture (OP2) chevauchant la première ouverture (OP1);
une deuxième couche de bord (163) disposée sur la première couche de bord (161) et incluant une pointe (TIP) faisant saillie vers la première ouverture (OP1);
une première couche électroluminescente (EL1) disposée sur la première électrode de pixel (AE1) et disposée au sein de la première ouverture (OP1);
une première électrode commune (CE1) disposée sur la première couche électroluminescente (EL1) et en contact avec la première couche de bord (161), au sein de la deuxième ouverture (OP2); et
une première couche d'encapsulation (171-1) disposée sur la première électrode commune (CE1) et la deuxième couche de bord (163),
dans lequel la pointe saillante de la deuxième couche de bord (163) inclut une surface latérale (163c) de la deuxième couche de bord (163) qui fait saillie vers la première ouverture (OP1) dans une plus grande mesure qu'une surface latérale (161c) de la première couche de bord (161),
dans lequel la première couche d'encapsulation (171-1) inclut une première couche inorganique (B11) recouvrant complètement la première électrode commune (CE1) et la pointe saillante (TIP) de la deuxième couche de bord (163), et une première couche de composé inorganique à base de silicium (S1) configurée pour planariser un gradin formé entre une partie inférieure de la pointe de la deuxième couche de bord et la surface latérale de la première couche de bord et disposée sur la première couche inorganique (B11),
dans lequel la première couche de composé inorganique à base de silicium (S1) inclut une première partie (S11) disposée sur la première électrode commune (CE1) et une deuxième partie (S12) disposée sur la deuxième couche de bord (163), et
dans lequel la première partie (S11) et la deuxième partie (S12) sont espacées l'une de l'autre.

2. Dispositif d'affichage (10, 20, 30, 50, 60, 70, 80, 90) selon la revendication 1, dans lequel la première couche de composé inorganique à base de silicium (S1) chevauche la pointe saillante de la deuxième couche de bord (163).

3. Dispositif d'affichage (10, 20, 30, 50, 60, 70, 80, 90) selon la revendication 1 ou 2, dans lequel la première partie (S11) recouvre complètement une partie de la première couche inorganique (B11) qui chevauche la première ouverture (OP1).

4. Dispositif d'affichage (10, 20, 30, 50, 60, 70, 80, 90) selon l'une des revendications précédentes, comportant en outre un premier motif d'électrode (CEP1) encerclant la première ouverture (OP1) sur la deuxième couche de bord (163) et incluant un même matériau que la première électrode commune (CE1),
dans lequel la première électrode commune (CE1) et le premier motif d'électrode (CEP1) sont espacés l'un de l'autre avec un espace interposé entre eux dans des parties de ceux-ci chevauchant la pointe saillante (TIP) de la deuxième couche de bord (163).

5. Dispositif d'affichage (10, 20, 30, 50, 60, 70, 80, 90) selon la revendication 4, dans lequel la première partie (S11) est disposée dans l'espace entre la première électrode commune (CE1) et le premier motif d'électrode (CEP1).

6. Dispositif d'affichage (10, 20, 30, 50, 60, 70, 80, 90) selon la revendication 4 ou 5, dans lequel la deuxième partie (S12) chevauche le premier motif d'électrode (CEP1) à l'extérieur de la première ouverture (OP1).

7. Dispositif d'affichage (10, 20, 30, 50, 60, 70, 80, 90) selon l'une des revendications précédentes, dans lequel la première couche de composé inorganique à base de silicium (S1) inclut de l'oxynitrure de silicium (SiON), du nitrure de silicium (SiN) ou de l'oxycarbure de silicium (SiOc).

8. Dispositif d'affichage (10, 20, 30, 50, 60, 70, 80, 90) selon l'une des revendications précédentes, dans lequel la première couche d'encapsulation (171-1) inclut en outre une deuxième couche inorganique (B12) recouvrant complètement la première couche de composé inorganique à base de silicium (S1) et une partie de la première couche inorganique (B11) qui chevauche la deuxième ouverture (OP2).

9. Dispositif d'affichage (10, 20, 30, 50, 60, 70, 80, 90) selon la revendication 8, comportant en outre une couche d'encapsulation organique (173) disposée sur la première couche d'encapsulation (171-1),
dans lequel une surface de la deuxième couche inorganique (B12) est en contact avec la première couche inorganique (B11) sur la surface latérale (163c) de la deuxième couche de bord (163).

10. Dispositif d'affichage (10, 20, 30, 50, 60, 70, 80, 90) selon la revendication 9, dans lequel une autre surface de la deuxième couche inorganique (B12) est en contact avec la couche d'encapsulation organique (173) sur la surface latérale (163c) de la deuxième couche de bord (163).

11. Dispositif d'affichage (10, 20, 30, 50, 60, 70, 80, 90) selon la revendication 9 ou 10, dans lequel la première couche inorganique (B11) inclut une partie (B11e) d'une première surface inclinée (B11e) qui chevauche l'extérieur de la deuxième ouverture (OP2),
dans lequel la première couche de composé inorganique à base de silicium (S1) inclut une deuxième surface inclinée (S12e) dans une partie de celle-ci chevauchant l'extérieur de la deuxième ouverture (OP2), et
dans lequel la deuxième couche inorganique (B12) inclut une troisième surface inclinée (B12e) dans une partie de celle-ci chevauchant un extérieur de la deuxième ouverture (OP2).

12. Dispositif d'affichage (10, 20, 30, 50, 60, 70, 80, 90) selon la revendication 11, dans lequel la première surface inclinée (B11e), la deuxième surface inclinée (S12e) et la troisième surface inclinée (B12e) sont alignées l'une avec l'autre, et
dans lequel la première surface inclinée (B11e), la deuxième surface inclinée (S12e) et la troisième surface inclinée (B12e) sont en contact avec la couche d'encapsulation organique (173).

13. Dispositif d'affichage (10, 20, 30, 50, 60, 70, 80, 90) selon la revendication 8, dans lequel la première couche d'encapsulation (171-1) inclut en outre:
une deuxième couche de composé inorganique à base de silicium (S1a) disposée sur la deuxième couche inorganique (B12) de façon à chevaucher la première ouverture (OP1); et
une troisième couche inorganique (B13) recouvrant complètement la deuxième couche de composé inorganique à base de silicium (S1a).

14. Dispositif d'affichage (10, 20, 30, 50, 60, 70, 80, 90) selon la revendication 13, dans lequel la première couche d'encapsulation (171-1) inclut en outre:
une troisième couche de composé inorganique à base de silicium (S1b) disposée sur la troisième couche inorganique (B13) de façon à chevaucher la première ouverture (OP1); et
une quatrième couche inorganique (B14) recouvrant complètement la troisième couche de composé inorganique à base de silicium (S1b).

15. Dispositif d'affichage (10, 20, 30, 50, 60, 70, 80, 90) selon l'une des revendications précédentes, comportant en outre:
une première structure de bord (160) disposée sur la zone de non-émission du substrat (110);
une deuxième structure de bord (160) espacée de la première structure de bord (160) avec une zone de séparation (SA) interposée entre elles, la première couche inorganique (B11) recouvrant la première structure de bord (160) et la deuxième structure de bord (160);
une deuxième couche inorganique (B12) disposée sur la première couche de composé inorganique à base de silicium (S1),
dans lequel chacune parmi la première structure de bord (160) et la deuxième structure de bord (160) inclut la première couche de bord (161) et la deuxième couche de bord (163), dans lequel une première surface (161a) disposée vers le substrat (110) de la première couche de bord (161) est plus grande qu'une deuxième surface (161b) de la première couche de bord (161) opposée à la première surface (161a),
et
dans lequel la première couche de composé inorganique à base de silicium (S1) est complètement encerclée par la première couche inorganique (B11) et la deuxième couche inorganique (B12) dans une partie de celle-ci chevauchant la zone de séparation (SA) entre la première structure de bord (160) et la deuxième structure de bord (160).
